# EUROPEAN PATENT APPLICATION

(11) **EP 4 622 432 A1**
(43) Date of publication of application: **24.09.2025**
(21) Application number: 25156990.1
(22) Date of filing: 11.02.2025
(51) Int. Cl.: H10K 59/80, H10K 59/122, H10K 59/124, H10K 102/00

(54) **DISPLAY DEVICE**

(30) Priority: 22.03.2024 KR 20240039475
(71) Applicant: SK hynix Inc., Bubal-eub Icheon-si Gyeonggi-do 17336 (KR)
(72) Inventor: HYEON, Young Hwan, 17336 Icheon-si, Gyeonggi-do (KR); NAM, Woo Hyun, 17336 Icheon-si, Gyeonggi-do (KR); PARK, Sul Young, 17336 Icheon-si, Gyeonggi-do (KR); EOM, Ji Na, 17336 Icheon-si, Gyeonggi-do (KR)
(74) Representative: Isarpatent

(57) **Abstract**

A display device is provided to include: a substrate which includes a plurality of sub-pixels; a transparent layer which is disposed in the plurality of sub-pixels, respectively; a first protective layer which is disposed on the transparent layer; and a second protective layer which is disposed on the first protective layer. The sub-pixel includes a light-emitting area where the transparent layer is exposed by the first protective layer and the second protective layer, and a non-light-emitting area around the light-emitting area.

## Description

### TECHNICAL FIELD

The present disclosure relates to a display device.

### BACKGROUND

With the development of the information society, various demands for a display device for displaying images are increasing. Various types of display devices such as a liquid crystal display, an organic light emitting diode display, etc., are being used.

The organic light-emitting display device among the display devices emits light by itself. Compared to the liquid crystal display device, the organic light-emitting display device has a larger viewing angle, a more excellent contrast ratio, etc., and requires no separate backlight, so that it can be lighter and thinner and is advantageous in terms of power consumption. Also, the organic light-emitting display device can be driven at direct current low voltage, and has a rapid response speed and a lower manufacturing cost.

Recently, there has been an increasing demand for a display device which uses such an organic light-emitting display device and requires augmented reality (AR), virtual reality (VR), or ultrahigh-resolution equivalent thereto.

On the other hand, a common light-emitting layer of the organic light-emitting display device includes a conductive charge generation layer. If the charge generation layer is formed integrally in a red sub-pixel, a green sub-pixel, and a blue sub-pixel, color mixing may occur between the sub-pixels.

### SUMMARY

Some implementations of the disclosed technology provide a display device including a transparent layer with an improved transmittance.

Some implementations of the disclosed technology provide the display device which includes an organic light-emitting device with an improved efficiency.

Some implementations of the disclosed technology provide the display device of which the transparent is prevented from being oxidized.

Some implementations of the disclosed technology provide a manufacturing method of the display device capable of protecting the transparent layer.

The present invention is set out by the appended claims.

A display device according to the present invention includes: a substrate which includes a plurality of sub-pixels; a transparent layer which is disposed in the plurality of sub-pixels, respectively; a first protective layer which is disposed on the transparent layer; and a second protective layer which is disposed on the first protective layer. The sub-pixel includes a light-emitting area where the transparent layer is exposed by the first protective layer and the second protective layer, and a non-light-emitting area around the light-emitting area.

A method for manufacturing a display device according to the present invention includes: forming a transparent layer on a substrate including a sub-pixel having a light-emitting area and a non-light-emitting area around the light-emitting area; forming a first protective layer on the transparent layer; performing a first etching on the transparent layer and the first protective layer; forming a second protective layer on the first etched first protective layer; performing a second etching on the second protective layer on the light-emitting area; and performing a third etching on the first protective layer on the light-emitting area.

The advantageous embodiments are provided in dependent claims. Other details of the embodiments are included in the detailed description and drawings.

According to the embodiments, in the manufacture of the display device, after the first protective layer is deposited on the whole surface of the whole surface deposited transparent layer, the transparent layer and the first protective layer can be separated (first etched) for each sub-pixel. The first etching is performed by using the first photoresist as a mask. After the first etching is completed, the first photoresist is removed through an ashing process. The ashing process uses oxygen plasma process. The transparent layer is manufactured to have a very small thickness in order to increase light transmittance. If the thin transparent layer is exposed to oxygen plasma, it may be oxidized. However, in the case of the display device according to the embodiments, during the process of removing the first photoresist, since the first protective layer is disposed on the transparent layer, the oxidation of the transparent layer can be prevented in advance.

According to the embodiments, in the manufacture of the display device, after the first etching and the removal of the first photoresist, in order to form the light-emitting area exposing the transparent layer and a non-light-emitting area in each sub-pixel, the second protective layer may be deposited on the transparent layer. The light-emitting area is formed by performing the second etching on the second protective layer. However, during the process of performing the second etching on the second protective layer, the transparent layer may be partially etched by the etching gas, resulting in difference in thickness for each portion. However, in the display device according to the embodiments, even during the process of performing the second etching on the second protective layer, the first protective layer is formed between the transparent layer and the second protective layer, thereby preventing the transparent layer from being partially etched by the etching gas.

According to the embodiments, during the process of performing the second etching on the second protective layer, the etching selection ratio of the second protective layer to the etching gas is three times or more than the etching selection ratio of the first protective layer to the etching gas and the etching selection ratio of the transparent layer to the etching gas, respectively, allowing the second protective layer to be selectively etched.

According to the embodiments, the second etching of the second protective layer is carried out using the second photoresist as a mask. After the second etching is completed, the second photoresist is removed through an ashing process. The ashing process uses oxygen plasma process. The transparent layer is manufactured to have a very small thickness in order to increase light transmittance. If the thin transparent layer is exposed to oxygen plasma, it may be oxidized. However, in the case of the display device according to the embodiments, during the process of removing the second photoresist, since the first protective layer is disposed on the transparent layer, the oxidation of the transparent layer can be prevented in advance.

According to the embodiments, after removing the second photoresist, the third etching is performed to remove the first protective layer on the light-emitting area. During the third etching process, the etching selection ratio of the first protective layer to the etchant is five times or more than the etching selection ratio of the second protective layer to the etchant and the etching selection ratio of the transparent layer to the etchant, respectively, allowing the first protective layer to be selectively etched.

However, advantageous effects according to the present disclosure are not limited by the foregoing description. Further, other unmentioned effects can be clearly understood from the following descriptions by those skilled in the art to which the present disclosure belongs.

### BRIEF DESCRIPTION OF THE DRAWINGS

FIG. 1 is a plan view of a display device based on some implementations of the disclosed technology.
FIG. 2 is a cross-sectional view taken along line A-A' of FIG. 1.
FIG. 3 is a cross-sectional view of an organic light-emitting device as shown in FIG. 2.
FIG. 4 is a cross-sectional view of an organic light-emitting device that is a modified example of an organic light-emitting device as shown in FIG. 2.
FIG. 5 is an enlarged view of a region Q1 of FIG. 2.
FIGS. 6 to 15 are cross-sectional views for respective process steps of a manufacturing method of a display device based on some implementations of the disclosed technology.
FIG. 16 is a cross-sectional view of a display device based on some implementations of the disclosed technology.

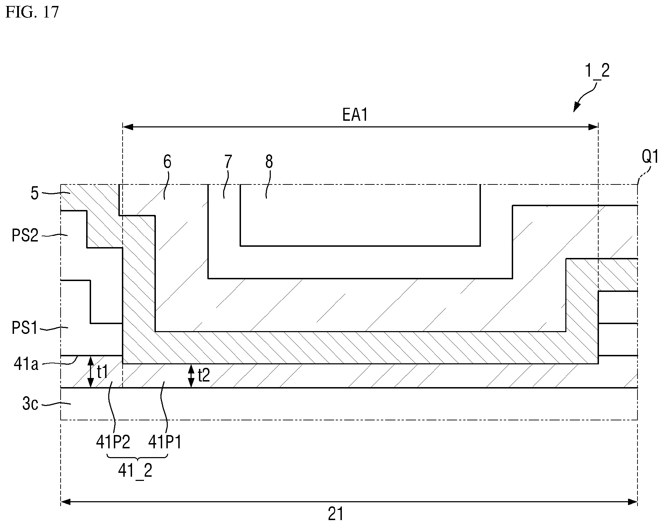

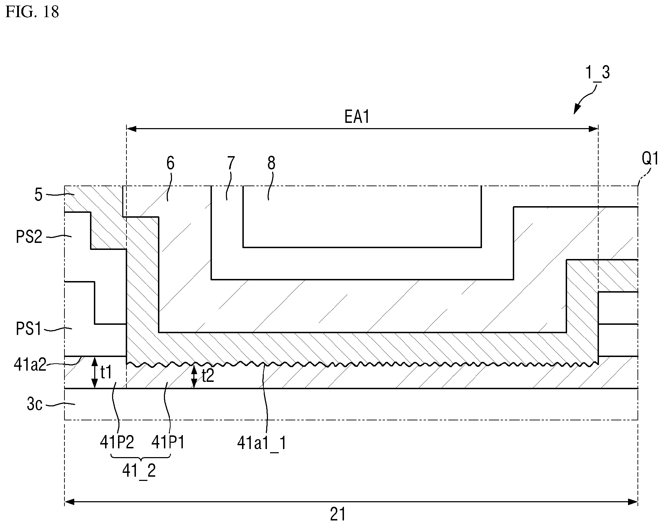

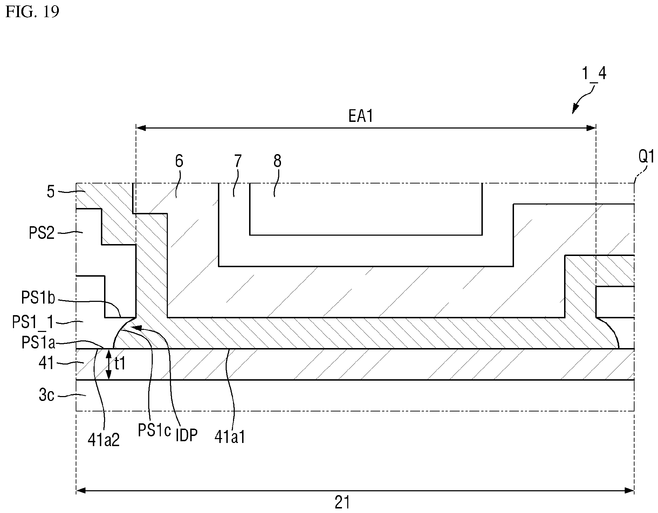

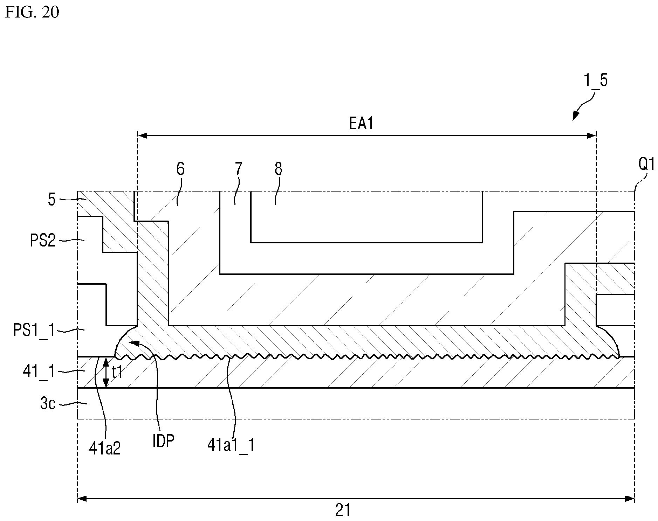

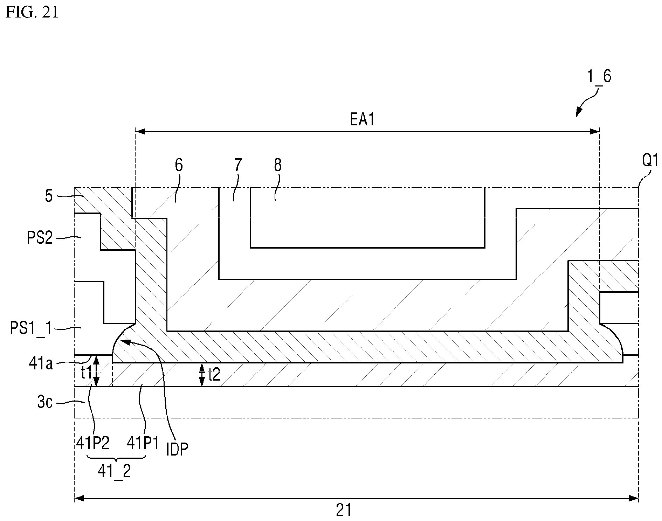

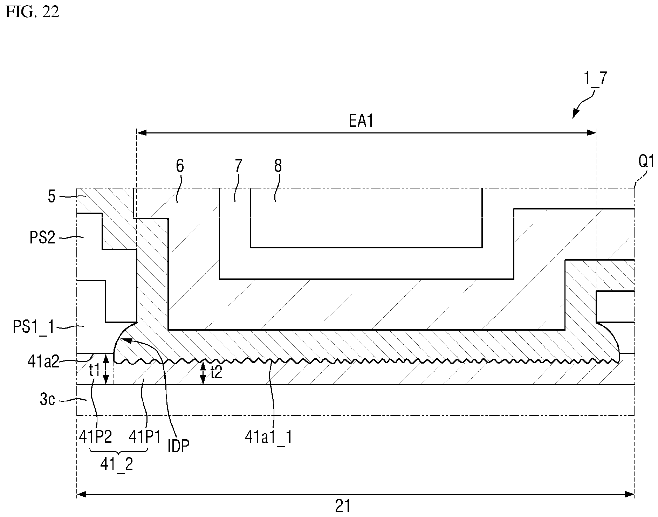

FIG. 17 is a cross-sectional view of a display device based on some implementations of the disclosed technology. FIG. 18 is a cross-sectional view of a display device based on some implementations of the disclosed technology. FIG. 19 is a cross-sectional view of a display device based on some implementations of the disclosed technology. FIG. 20 is a cross-sectional view of a display device based on some implementations of the disclosed technology. FIG. 21 is a cross-sectional view of a display device based on some implementations of the disclosed technology. FIG. 22 is a cross-sectional view of a display device based on some implementations of the disclosed technology.

### DETAILED DESCRIPTION

Hereinafter, embodiments of the present disclosure will be described with reference to the accompanying drawings.

The same reference numerals correspond to the same components. Also, in the drawings, the thicknesses, ratios, and dimensions of the components are exaggerated for effective description of the technical details. A term "and/or" includes all of one or more combinations that related configurations can define.

While terms such as the first and the second, etc., can be used to describe various components, the components are not limited by the terms mentioned above. The terms are used only for distinguishing between one component and other components. For example, the first component may be designated as the second component without departing from the scope of rights of various embodiments. Similarly, the second component may be designated as the first component. An expression of a singular form includes the expression of plural form thereof unless otherwise explicitly mentioned in the context.

Terms such as "below", "lower", "above", "upper" and the like are used to describe the relationships between the components shown in the drawings. These terms have relative concepts and are described based on directions indicated in the drawings.

Terms used in the present specification are provided for description of only specific embodiments of the present invention, and not intended to be limiting. An expression of a singular form includes the expression of plural form thereof unless otherwise explicitly mentioned in the context. In the present specification, it should be understood that the term "include" or "comprise" and the like is intended to specify characteristics, numbers, steps, operations, components, parts or any combination thereof which are mentioned in the specification, and intended not to previously exclude the possibility of existence or addition of at least one another characteristics, numbers, steps, operations, components, parts or any combination thereof.

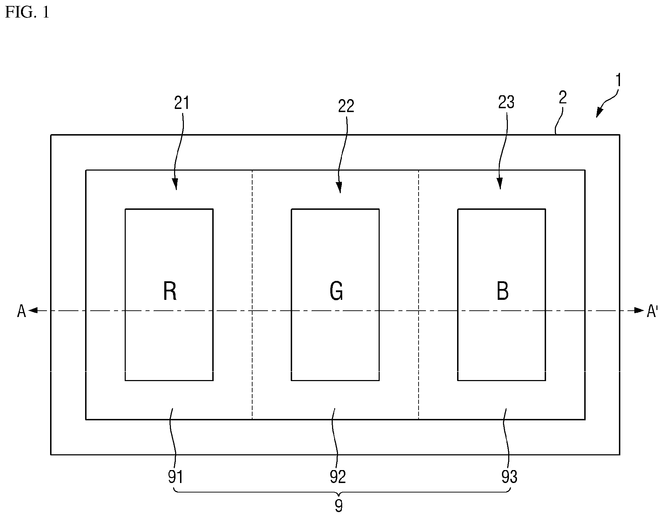

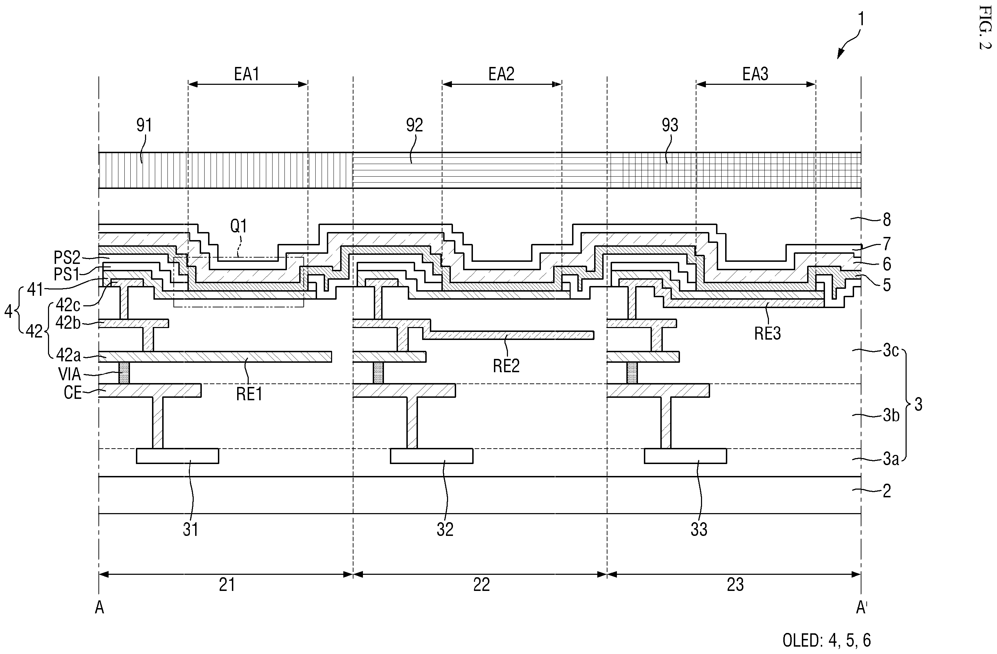

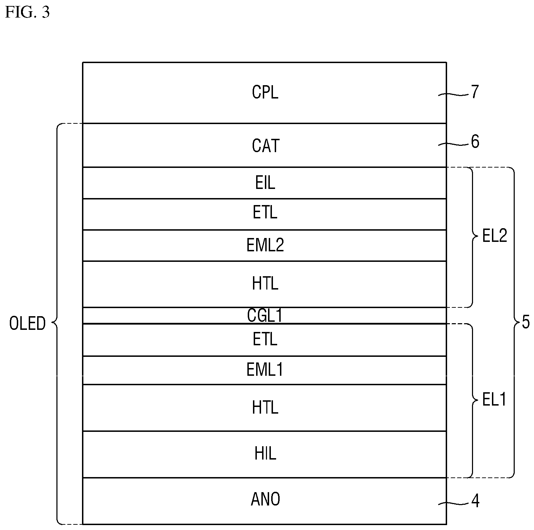

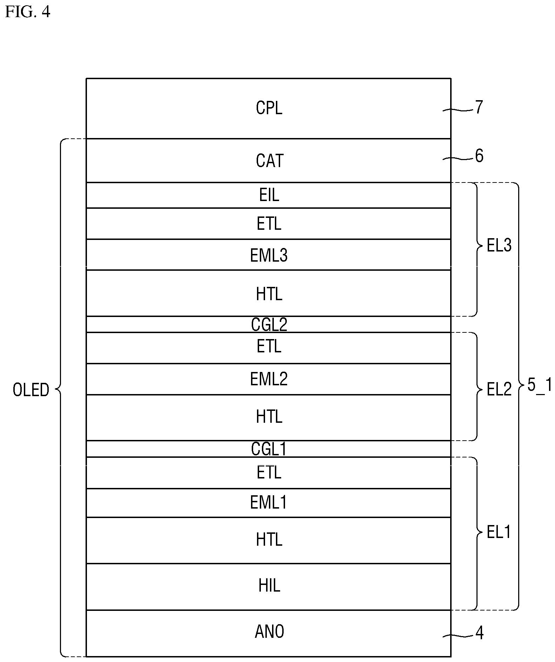

FIG. 1 is a plan view of a display device according to an embodiment. FIG. 2 is a cross-sectional view taken along line A-A' of FIG. 1. FIG. 3 is a cross-sectional view of an organic light-emitting device as shown in FIG. 2. FIG. 4 is a cross-sectional view of the organic light-emitting device that is a modified example of the organic light-emitting device as shown in FIG. 2.

Referring to FIGS. 1 to 4, a display device 1 according to the embodiment includes a substrate 2, a first electrode 4, a common light-emitting layer 5 that emits light, and a second electrode 6.

A plurality of sub-pixels 21, 22, and 23 are formed on the substrate 2 at different locations of, and share, the common light-emitting layer 5 to generate light from the light emission of the common light-emitting layer 5. In various implementations, the plurality of sub-pixels 21, 22, and 23 may be configured to include color filters within the sub pixels so that the light emitted from their respective regions of the common light-emitting layer 5 may be filtered to be in different colors. In certain implementations, the plurality of sub-pixels 21, 22, and 23 may be grouped form one pixel. A plurality of pixels may be formed on the substrate 2. The substrate 2 may include the plurality of sub-pixels 21, 22, and 23.

The plurality of sub-pixels 21, 22, and 23 includes a first sub-pixel 21, a second sub-pixel 22, and a third sub-pixel 23. The first sub-pixel 21, the second sub-pixel 22, and the third sub-pixel 23 are arranged in a certain spatial order, so that the second sub-pixel 22 is disposed adjacent to on one side, e.g., the left side, of the first sub-pixel 21, and the third sub-pixel 23 is disposed adjacent to one side, e.g., the left side, of the second sub-pixel 22.

In some implementations, when two sub-pixels are disposed adjacent to each other, the two sub-pixels may be disposed relative to each out without having any other sub-pixel disposed between the two sub-pixels.

In certain implementations where the plurality of sub-pixels 21, 22, and 23 may be configured to include color filters within their sub pixels so that the light emitted from their respective regions of the common light-emitting layer 5 may be filtered to be in different colors for producing desired color images. For example, the first sub-pixel 21 may be configured to include a red-transmitting color filter to filter the light emitted by its region within the common light-emitting layer 5 to outpout red light R, the second sub-pixel 22 may be configured to include a green-transmitting color filter to filter the light emitted by its region within the common light-emitting layer 5 to outpout green light G, and the third sub-pixel 23 may be configured to include a blue-transmitting color filter to filter the light emitted by its region within the common light-emitting layer 5 to outpout blue light B. However, such an implementation of adjacent sub pixels for outpoutting light of different colors is one example only and other implementations of the color arrangements for the adjacent sub pixels are also possible.

FIG. 1 shows that the pixel includes only three sub-pixels 21, 22, and 23, but other implementations of different number of adjacent sub pixels are also possible. For example, the pixel may include four adjacent sub-pixels. When the pixel includes four sub-pixels that output light of different colors such as red R, green G and blue B, the pixel may further include a fourth sub-pixel configured to emit white light W.

In the implementation, the first to third sub-pixels 21, 22, and 23 may each be structured to have the same sub pixel size. For example, the first to third sub-pixels 21, 22, and 23 may each be provided with the same width and the same height. Here, the width may refer to a horizontal direction based on FIG. 1, and the height may refer to a direction perpendicular to the width based on FIG. 1. However, such implementation is the example only and other implementations are also possible.

A first protective layer PS1 and a second protective layer PS2 may be disposed in each of the first sub-pixel 21, the second sub-pixel 22, and the third sub-pixel 23. The first protective layer PS1 and the second protective layer PS2 may function as a bank that defines light-emitting areas EA1, EA2, and EA3 of the sub-pixels 21, 22, and 23. Referring to FIG. 2, in each of the first sub-pixel 21, the second sub-pixel 22, and the third sub-pixel, the first protective layer PS1 is disposed on the transparent layer 41 and the second protective layer PS2 is disposed on the first protective layer PS1. The first protective layer PS1 and the second protective layer PS2 may be formed on the same layer in the first sub-pixel, the second sub-pixel 22 and the third sub-pixel 23.

The first electrode 4 is patterned separately for each sub-pixel 21, 22, and 23. In some implementations, one first electrode 4 is formed in the first sub-pixel 21, and another first electrode 4 is formed in the second sub-pixel 22. Also, a further another first electrode 4 is formed in the third sub-pixel 23. In some implementations, the first electrode 4 disposed in the first sub-pixel 21, the second sub-pixel 22, and the third sub-pixel 23 are different portions of the first electrode 4. The first electrode 4 may function as an anode of the display device 1. The bank BK is provided to cover the edge of the first electrode 4 disposed in the first to third sub-pixels 21, 22, and 23, respectively, thereby dividing the first sub-pixel 21, the second sub-pixel 22, and the third sub-pixel 23 into regions on which the bank BK including the first protective layer PS1 and the second protective layer PS2 is provided and another regions without the bank BK . Therefore, the light-emitting area can be defined by the first and second protective layers PS1 and PS2. For example, the first protective layer PS1 and the second protective layer PS2 are provided in the non-light-emitting area, while the first protective layer PS1 and the second protective layer PS2 are not provided in the light-emitting areas EA1, EA2, EA3.

In the display device 1, the first electrode 4 is formed as multiple layers including a reflective layer 42. Therefore, the display device 1 can further improve light extraction efficiency by using micro-cavity characteristics.

Due to the micro-cavity characteristics, when a distance between the reflective layer 42 and the second electrode 6 is an integer multiple of half (λ/2) the wavelength of the light emitted from the sub-pixel, constructive interference occurs and the light is amplified. In addition, when reflection and re-reflection are repeated between the reflective layer 42 and the second electrode 6, the micro-cavity characteristics allows to continuously increase the degrees of the light amplification, thereby improving the external extraction efficiency of the light.

The common light-emitting layer 5 may be configured to emit white light which includes light components at different colors. For example, the common light-emitting layer 5 may be provided with a two-stack structure including a blue light-emitting layer that emits light in blue, a yellow-green light-emitting layer that emits light in yellow, and a charge generation layer, thereby collectively emitting white light by combining the emitted light in blue and yellow, or a three-stack structure including a blue light-emitting layer that emits light in blue, a green light-emitting layer that emits light in green, a red light-emitting layer that emits light in red, and the charge generation layer, thereby collectively emitting white light by combining the emitted light in blue, green and red. In addition to the above two color design examples, the common light-emitting layer 5 may be structured in other light emitting structures to produce white light. For example, the common light-emitting layer 5 may be provided as multiple layers including more than three stacks as long as the common light-emitting layer 5 can emit white light.

The common light-emitting layer 5 may be formed as a common layer that is located across, and shared by, the entire first to third sub-pixels 21, 22, and 23. Therefore, the common light-emitting layer 5 may cover the first electrode 4 disposed in each sub-pixel and the first and second protective layers PS1 and PS2 disposed in each of the sub-pixels, and between the sub-pixels.

The second electrode 6 is provided to form an electric field together with the first electrode 4 and may function as a cathode. The second electrode 6 is disposed on the top surface of the common light-emitting layer 5 opposite to the bottom surface of the common light-emitting layer 5 where the first electrode 4 is in contact, and may be provided as a common layer across the entire first to third sub-pixels 21, 22, and 23.

In the case of a top emission type, the second electrode 6 may be provided as a transparent electrode that provides an electrical contract while transmitting light emitted by the common light-emitting layer 5 and the the entire first to third sub-pixels 21, 22, and 23. In the case of a bottom emission type, the second electrode 6 may be provided as an opaque electrode including a reflective material. In the case of the top emission type, the second electrode 6 may be formed as a translucent electrode in order to improve light extraction efficiency by using micro-cavity characteristics. Since the display device improves the light extraction efficiency by using the micro-cavity characteristics in the top emission type, the second electrode formed as a translucent electrode will be described as an example.

The sub-pixels formed based on the common light-emitting layer 5, e.g., the first to third sub-pixels 21, 22, and 23, may be designed to include color filters, respectively, one color filter per sub-pixel, to filter the common light emitted by the the common light-emitting layer 5 to produce different output light from different sub-pixels in desired colors for the sub-pixels. For example, a color filter layer 9 is provided in each of the first to third sub-pixels 21, 22, and 23 to include different color filters at different sub-pixels to block a specific color from the light emitted from the light-emitting layer 5 of each sub-pixel. As a specific example shown in FIG. 1, the color filter layer 9 may include a first color filter 91 located in the first sub-pixel 21 to transmit light of a red color and to block transmission of light of colors other than red light R. In this case, the first color filter 91 is a red color filter. In addition, in FIG. 1, the color filter layer 9 may include a second color filter 92 located in the second sub-pixel 22 to transmit light of a green color and to block transmission of light of colors other than green light G. In this case, the second color filter 92 is a green color filter. Furthermore, the color filter layer 9 in FIG. 1 may include a third color filter 93 located in the third sub-pixel 23 to transmit light of a blue color and to block transmission of light of colors other than blue light B. In this case, the third color filter 93 is a blue color filter. Other designs of color filters different from the above red, green and blue arrangement may be possible.

In some implementations, the first to third color filters 91, 92, and 93 provided in the first to third sub-pixels 21, 22, and 23, respectively, may be provided with the same sizes as those of the sub-pixels . In some implementations, the first to third color filters 91, 92, and 93 may be provided with different sizes from the sub-pixels, for example, by being reduced or enlarged by a certain ratio to the sizes of the sub-pixels.

Hereinafter, a stacked structure of the display device 1 according to the embodiment will be described in detail.

The display device 1 according to the embodiment includes the substrate 2, an insulating layer 3, the first electrode 4, the first protective layer PS1, the second protective layer PS2, the common light-emitting layer 5, the second electrode 6, a capping layer 7, an encapsulation layer 8, and the color filter layer 9.

The substrate 2 may be a plastic film, a glass substrate, or a semiconductor substrate such as silicon.

The substrate 2 may be formed of or include a transparent material or an opaque material. On the substrate 2, the first sub-pixel 21, the second sub-pixel 22, and the third sub-pixel 23 are provided. The first sub-pixel 21 may be configured to emit red light R, the second sub-pixel 22 may be configured to emit blue light B, and the third sub-pixel 23 may be configured to emit green light G.

In some implementations, the display device 1 is formed in a top emission type in which the emitted light is emitted upward. Therefore, not only a transparent material but also an opaque material can be used as the material of the substrate 2. In the upper portions of the first to third sub-pixels 21, 22, and 23 from which the light is emitted, the color filters 91, 92, and 93 may be provided in order to transmit the light of the colors mentioned above.

The insulating layer 3 is formed on the substrate 2. The insulating layer 3 may include a plurality of stacked insulating layers 3a, 3b, and 3c. The insulating layers 3a, 3b, and 3c according to the embodiment may be stacked sequentially in the thickness direction thereof and may include the same material. However, the insulating layers 3a, 3b, and 3c are not limited thereto, and may include different materials. In the insulating layer 3, circuit elements including a plurality of thin-film transistors 31, 32, and 33, various signal wirings, and capacitors are provided for each of the sub-pixels 21, 22, and 23. The signal wirings may include a gate line, a data line, a power line, and a reference line. The thin-film transistors 31, 32, and 33 may include a switching thin-film transistor, a driving thin-film transistor, and a sensing thin-film transistor. Each of the sub-pixels 21, 22, and 23 is defined by an intersecting structure of the gate lines and data lines.

The switching thin-film transistor is switched according to a gate signal supplied to the gate line and serves to supply a data voltage supplied from the data line to the driving thin-film transistor.

The driving thin-film transistor is switched according to the data voltage supplied from the switching thin-film transistor and serves to generate a data current from the power supplied from the power line and to supply the data current to the first electrode 4.

The sensing thin-film transistor serves to sense a threshold voltage deviation of the driving thin-film transistor, which is a cause of deterioration of image quality. The sensing thin-film transistor responds to a sensing control signal supplied from the gate line or a separate sensing line, and supplies the current of the driving thin-film transistor to the reference line.

The capacitor serves to maintain the data voltage supplied to the driving thin-film transistor for one frame. The capacitor is connected to a gate terminal and a source terminal of the driving thin-film transistor, respectively.

The first transistor 31, the second transistor 32, and the third transistor 33 are disposed for the sub-pixels 21, 22, and 23, respectively, within the first insulating layer 3a. The first transistor 31 may be connected to the first electrode 4 disposed on the first sub-pixel 21 and may apply a driving voltage for emitting light of a color corresponding to the first sub-pixel 21.

The second transistor 32 may be connected to the first electrode 4 disposed on the second sub-pixel 22 and may apply a driving voltage for emitting light of a color corresponding to the second sub-pixel 22.

The third transistor 33 may be connected to the first electrode 4 disposed on the third sub-pixel 23 and may apply a driving voltage for emitting light of a color corresponding to the third sub-pixel 23.

When the first sub-pixel 21, the second sub-pixel 22, and the third sub-pixel 23 receive the gate signal from the gate line through use of the transistors 31, 32, and 33, respectively, a predetermined current is supplied to the light-emitting layer according to the data voltage of the data line. As a result, the light-emitting layer of each of the first sub-pixel 21, the second sub-pixel 22, and the third sub-pixel 23 can emit light with a predetermined brightness according to the predetermined current.

The first insulating layer 3a can protect the transistors 31, 32, and 33. The first insulating layer 3a may be formed of or include an organic insulating material, but the first insulating layer 3a is not necessarily limited thereto. The first insulating layer 3a may be formed of or include an inorganic insulating material. The transistors 31, 32, and 33 may be located within the first insulating layer 3a.

A connection electrode CE may be disposed in the sub-pixels 21, 22, and 23, respectively, on the first insulating layer 3a. The second insulating layer 3b may be disposed on the first insulating layer 3a. The connection electrode CE may be disposed within the second insulating layer 3b, but the connection electrode CE is not limited thereto. The connection electrode CE is patterned for each of the first to third sub-pixels 21, 22, and 23. The connection electrode CE may be electrically connected to the transistors 31, 32, and 33. The second insulating layer 3b may be formed of or include an organic insulating material, but it is not necessarily limited thereto. The second insulating layer 3b may be formed of or include an inorganic insulating material.

On the second insulating layer 3b, the reflective layer to be described later or the first electrode 4 of the first sub-pixel 21 may be disposed. The first electrode 4 is patterned for each of the first to third sub-pixels 21, 22, and 23. The first electrode 4 is connected to the driving thin-film transistor provided in the insulating layer 3. For example, the first electrode 4 may be electrically connected to the transistors 31, 32, and 33 through the aforementioned connection electrode CE.

The display device 1 according to the embodiment is formed in a top emission type. In the implementations, the first electrode 4 may be configured to reflect upward the light emitted from the common light-emitting layer 5. In this case, the first electrode 4 may have a double-layer structure including the reflective layer 42 (or a reflective electrode or a reflective plate) for reflecting light, and a transparent layer 41 (or a transparent electrode or an anode electrode) for supplying holes to the common light-emitting layer 5.

The reflective layer 42 may reflect the light emitted toward the reflective layer 42 among the light emitted from the common light-emitting layer 5 of each of the sub-pixels 21, 22, and 23 to the second electrode 6 or the encapsulation layer 8. Also, the reflective layer 42 is for implementing the micro-cavity characteristics through reflection and re-reflection with the second electrode 6. In the implementations, the reflective layer 42 may include a reflective material for reflecting light. For example, the reflective material may be or include a metal, but it is not necessarily limited thereto. The reflective material may be or include any other materials as long as they can reflect light. For example, the reflective material may include Ti/Al, but it is not limited thereto.

Since the reflective layer 42 is disposed at a relatively lower position than the common light-emitting layer 5 that emits light, the reflective layer 42 can reflect upward the light emitted from the common light-emitting layer 5. Here, the upward refers to a direction in which a user can perceive the light. For example, the upward may refer to a side where the encapsulation layer 8 or the color filter layer 9 is disposed. Accordingly, the first sub-pixel 21, the second sub-pixel 22, and the third sub-pixel 23 can have an improved light efficiency compared to a case where there is no reflective layer 42, and the user can perceive a high-brightness image, i.e., a clear image through the improved light efficiency.

As described above, through the first electrode 4 composed of or including multiple layers including the reflective layer 42, the display device 1 can further improve the light extraction efficiency by using the microcavity characteristics. The reflective layer 42 may be disposed within the third insulating layer 3c, but is not limited thereto. The reflective layer 42 may include a first reflective layer 42a, a second reflective layer 42b, and a third reflective layer 42c. The first reflective layer 42a may be electrically connected to the connection electrode CE through a via VIA. In the first sub-pixel 21, the first reflective layer 42a may include a first reflective electrode RE1 that overlaps the transparent layer 41 of the first sub-pixel 21. The second reflective layer 42b may be disposed on the first reflective layer 42a and may be electrically connected to the first reflective layer 42a. In the second sub-pixel 22, the second reflective layer 42b may include a second reflective electrode RE2 that overlaps the transparent layer 41 of the second sub-pixel 22. A distance between the first reflective electrode RE1 and the transparent layer 41 may be greater than a distance between the second reflective electrode RE2 and the transparent layer 41. The third reflective layer 42c may be disposed on the second reflective layer 42b and may be electrically connected to the second reflective layer 42b. In the third sub-pixel 23, the third reflective layer 42c may include a third reflective electrode RE3 that overlaps the transparent layer 41 of the third sub-pixel 23. A distance between the second reflective electrode RE2 and the transparent layer 41 may be greater than a distance between the third reflective electrode RE3 and the transparent layer 41. The third reflective electrode RE3 may directly contact the transparent layer 41, but is not limited thereto. The third reflective layer 42c may directly contact the transparent layer 41 corresponding to each of the sub-pixels 21, 22, and 23, but is not limited thereto. While the first and second reflective layers 42a and 42b are located within the third insulating layer 3c, the third reflective layer 42c may be located on the top surface of the third insulating layer 3c, but they are not limited thereto. The second electrodes 6 in the light-emitting areas EA1, EA2, and EA3 of the sub-pixel 21, 22, and 23 may be located on the same line. Therefore, a size relationship of the distances between the reflective electrodes RE1, RE2, and RE3 and the transparent layer 41 in the sub-pixels 21, 22, and 23 may be the same as a size relationship of the distances between the reflective electrodes RE1, RE2, and RE3 and the second electrode 6.

The reflective layers 42 of the sub-pixels 21, 22, and 23 may be electrically connected to the transistors 31, 32, and 33 through the connection electrode CE.

As such, the reflective electrodes RE1, RE2, and RE3 are formed to have various spaced distances (or resonance distances) from the second electrode 6 because the light extraction efficiency of light of different colors can be improved through reflection and re-reflection between the reflective electrodes RE1, RE2, and RE3 and the second electrode 6 according to the spaced distance. Therefore, the light extraction efficiency of red light may be improved in the first sub-pixel 21, the light extraction efficiency of green light may be improved in the second sub-pixel 22, and the light extraction efficiency of blue light may be improved in the third sub-pixel 23.

The transparent layer 41 is disposed on the reflective layer 42. The transparent layer 41 is for supplying holes to the common light-emitting layer 5. The transparent layer 41 may be transparent such that the light reflected from the reflective layer 42 can travel upward. The transparent layer 41 may be formed of or include a transparent material, but is not limited thereto. The transparent layer 41 may be formed in the form of a thin film of any metal material capable of transmitting light. For example, the transparent layer 41 may include titanium nitride (TiN), but is not limited thereto. The transparent layer 41 may be formed in the form of a very thin film such that the light reflected from the reflective layer 42 can travel upward. For example, the thickness of the transparent layer 41 may be about 5 nm or less. For example, the thickness of the transparent layer 41 may be about 3 nm or less, but is not limited thereto.

The transparent layer 41 may be electrically connected to the reflective layer 42 by directly contacting the reflective layer 42, or may be electrically connected to the reflective layer 42 by being indirectly connecting to the reflective layer 42 through a contact hole. The reflective layer 42 is connected to the first to third transistors 31, 32, and 33 respectively through another contact hole, so that the driving voltage provided by each of the first to third transistors 31, 32, and 33 can be applied to the transparent layer 41. When the driving voltage is applied from the first to third transistors 31, 32, and 33, the transparent layer 41 can supply holes to the common light-emitting layer 5. In each of the sub-pixels 21, 22, and 23, the transparent layer 41 may directly contact the third reflective layer 42c and may reflect a step difference formed by the third reflective layer 42c.

The transparent layer 41 may be disposed for each of the first to third sub-pixels 21, 22, and 23 in such a manner as to have almost the same height on the top surface of the reflective layer 42 or the insulating layer 3. Also, the reflective layer 42 may have the same width as that of the transparent layer 41, but is not necessarily limited thereto. The reflective layer 42 may have a greater width than that of the transparent layer 41 in order to further increase the amount of upwardly reflected light.

The transparent layers 41 in the sub-pixels 21, 22, and 23 are disposed in the light-emitting areas EA1, EA2, and EA3, and may also be disposed in a portion of a non-light-emitting area. However, the transparent layers 41 disposed in the sub-pixels 21, 22, and 23 may be physically separated from the transparent layers 41 disposed in the sub-pixels 21, 22, and 23 adjacent thereto. The physical separation between the transparent layers 41 of the sub-pixels 21, 22, and 23 and the transparent layers 41 of the adjacent sub-pixels 21, 22, and 23 may be made through a first etching to be described later. In the process of separating the transparent layers 41 through the first etching, the first protective layer PS1 between the sub-pixels 21, 22, and 23 can also be separated together with the transparent layer 41. Therefore, the first protective layer PS1 may not be disposed in an area where the transparent layer 41 is not disposed. For example, as shown in FIG. 2, the first protective layer PS1 may not be disposed in the separated area between the transparent layer 41 of the first sub-pixel 21 and the transparent layer 41 of the second sub-pixel 22. The first protective layer PS1 may be disposed on the transparent layer 41. The first protective layer PS1 may be formed of or include an inorganic material such as silicon nitride SiNx, silicon oxide SiOx, aluminum oxide Al2O3, etc. However, the embodiments of the present disclosure are not limited thereto. For example, the first protective layer PS1 may include aluminum oxide Al2O3, but is not limited thereto.

The second protective layer PS2 may be disposed on the first protective layer PS1. The second protective layer PS2 may be disposed on the boundaries of adjacent sub-pixels 21, 22, and 23. The second protective layer PS2 may be disposed in the non-light-emitting areas of the sub-pixels 21, 22, and 23, and may not be disposed in the light-emitting areas EA1, EA2, and EA3. Unlike the first protective layer PS1, the second protective layer PS2 may be disposed in the area where the transparent layer 41 is not disposed. Therefore, as shown in FIG. 2, in the area where the transparent layers 41 of the adjacent sub-pixels 21, 22, and 23 are separated, the second protective layer PS2 may directly contact the underlying insulating layer 3 (e.g., the third insulating layer 3c). Also, in the area where the transparent layers 41 of the adjacent sub-pixels 21, 22, and 23 are separated, the second protective layer PS2 may directly contact a side surface of the first protective layer PS1 and side and top surfaces of the transparent layer 41, respectively. The second protective layer PS2 may be formed of or include an inorganic material such as silicon nitride SiNx, silicon oxide SiOx, aluminum oxide Al2O3, etc. However, the embodiments of the present disclosure are not limited thereto. For example, the second protective layer PS2 may include silicon nitride SiNx or silicon oxide SiOx, but is not limited thereto.

The common light-emitting layer 5 is formed on the first electrode 4 and the protective layers PS1 and PS2. The common light-emitting layer 5 may also be formed on the second protective layer PS2 disposed between the plurality of sub-pixels 21, 22, and 23. The common light-emitting layer 5 may contact the top surface of the transparent layer 41 of the first electrode 4. The common light-emitting layer 5 may directly contact the side surface of the first protective layer PS1 and the side and top surfaces of the second protective layer PS2.

According to the embodiment, the organic light-emitting device (OLED) may include the first electrode (ANO) 4, the second electrode (CAT) 6, and the common light-emitting layer 5 between the first electrode 4 and the second electrode 6.

The common light-emitting layer 5 may be configured to emit white light W. To this end, the common light-emitting layer 5 may be formed to include a plurality of stacks that emits light of different colors. Specifically, the common light-emitting layer 5 may be formed to include a first stack, a second stack, and the charge generation layer (CGL) disposed between the first stack and the second stack.

The second electrode 6 is formed on the common light-emitting layer 5. The second electrode 6 may function as a cathode of the display device 1. As with the common light-emitting layer 5, the second electrode 6 is also formed in the sub-pixels 21, 22, and 23 respectively and between the sub-pixels.

In the display device 1 according to the embodiment, the second electrode 6 may be formed as a translucent electrode in order to create light efficiency white light in the top emission manner. Accordingly, a micro cavity effect can be obtained for each of the first to third sub-pixels 21, 22, and 23. When the second electrode 6 is formed as a translucent electrode, the micro cavity effect through repeated reflection and re-reflection of light between the second electrode 6 and the reflective layer 42 can be obtained, so that the light extraction efficiency can be improved.

Meanwhile, since the second electrode 6 is formed on the top surface of the common light-emitting layer 5, the second electrode 6 may be formed following the profile of the common light-emitting layer 5. Since the common light-emitting layer 5 is formed to follow the profile of the transparent layer 41 of the first electrode 4 in the light-emitting area, the second electrode 6 may consequently be formed to follow the profile of the transparent layer 41 of the first electrode 4. Also, the capping layer 7 on the second electrode 6 may also be formed to follow the profile of the second electrode 6.

The capping layer 7 may be formed of or include an inorganic insulating material, but is not limited thereto. The capping layer 7 may be disposed on the second electrode 6 to protect the organic light-emitting device (OLED).

The encapsulation layer 8 is formed on the second electrode 6 and serves to prevent outside moisture from penetrating into the common light-emitting layer 5. Such an encapsulation layer 8 may be formed of or include an inorganic insulating material, or may be formed to have a structure in which an inorganic insulating material and an organic insulating material are alternately stacked, but it is not necessarily limited thereto.

The color filter layer 9 is formed on the encapsulation layer 8. The color filter layer 9 may be formed to include the first color filter 91 of red R provided in the first sub-pixel 21, the second color filter 92 of green G provided in the second sub-pixel 22, and the third color filter 93 of blue B provided in the third sub-pixel 23, but is not necessarily limited thereto.

As shown in FIG. 3, the common light-emitting layer 5 may be formed to include the first stack EL1, the second stack EL2, and a first charge generation layer CGL1 provided on the first electrode 4.

The first stack EL1 is provided on the first electrode 4 and may be formed to have a structure in which a hole injecting layer HIL, a hole transporting layer HTL, a blue B emitting layer EML1, and an electron transporting layer ETL are sequentially stacked.

The first stack EL1 may also be disposed between the first sub-pixel 21 and the second sub-pixel 22, and between the second sub-pixel 22 and the third sub-pixel 23, that is to say, on the bank BK.

The first charge generation layer CGL1 serves to supply charges to the first stack EL1 and the second stack EL2. The first charge generation layer CGL1 may be formed to include an N-type charge generation layer for supplying electrons to the first stack EL1 and a P-type charge generation layer for supplying holes to the second stack EL2. The N-type charge generation layer may be formed to include a metal material as a dopant.

The second stack EL2 is provided on the first stack EL1 and may be formed to have a structure in which the hole transporting layer HTL, a yellow green YG emitting layer EML2, an electron transporting layer ETL, and an electron injecting layer EIL are sequentially stacked.

The second stack EL2 may also be disposed between the first sub-pixel 21 and the second sub-pixel 22, and between the second sub-pixel 22 and the third sub-pixel 23, that is to say, on the bank BK.

As a result, the common light-emitting layer 5 may be, as shown in FIG. 2, provided as a common layer throughout the first to third sub-pixels 21, 22, and 23.

As shown in FIG. 4, according to the embodiment, a common light-emitting layer 5_1 of the organic light-emitting device (OLED) may be formed to include a first stack EL1, a second stack EL2, a third stack EL3, a first charge generation layer CGL1 between the first stack EL1 and the second stack EL2, and a second charge generation layer CGL2 between the second stack EL2 and the third stack EL3, which are provided on the first electrode 4.

The first stack EL1 is provided on the first electrode 4 and may be formed to have a structure in which a hole injecting layer HIL, a hole transporting layer HTL, a blue B emitting layer EML1, and an electron transporting layer ETL are sequentially stacked.

The first stack EL1 may also be disposed between the first sub-pixel 21 and the second sub-pixel 22, and between the second sub-pixel 22 and the third sub-pixel 23, that is to say, on the bank BK.

The first charge generation layer CGL1 serves to supply charges to the first stack EL1 and the second stack EL2. The first charge generation layer CGL1 may be formed to include an N-type charge generation layer for supplying electrons to the first stack EL1 and a P-type charge generation layer for supplying holes to the second stack EL2. The N-type charge generation layer may be formed to include a metal material as a dopant.

The first charge generation layer CGL1 may also be disposed between the first sub-pixel 21 and the second sub-pixel 22, and between the second sub-pixel 22 and the third sub-pixel 23, that is to say, on the bank BK. Meanwhile, in the display device 1 according to the embodiment, since the common light-emitting layer 5 is also disposed between the sub-pixels 21, 22, and 23, a lateral leakage current may occur to adjacent sub-pixels 21, 22, and 23 through the first charge generation layer CGL1 when one of the sub-pixels emits light. However, since a bank BK having a certain height is disposed between the sub-pixels 21, 22, and 23, it is possible to prevent that a current path becomes longer and thus the lateral leakage current occurs. Furthermore, since the bank BK has an asymmetric shape, the thickness of the first charge generation layer CGL1 can be reduced at least on one side of the bank BK. As a result, the first charge generation layer CGL1 can be physically separated at least on one side of the bank BK. A detailed description of this will be provided later.

The second stack EL2 is provided on the first stack EL1 and may be formed to have a structure in which a hole transporting layer HTL, a green G emitting layer EML2, and an electron transporting layer ETL.

The second stack EL2 may also be disposed between the first sub-pixel 21 and the second sub-pixel 22, and between the second sub-pixel 22 and the third sub-pixel 23, that is to say, on the bank BK.

The second charge generation layer CGL2 serves to supply charges to the second stack EL2 and the third stack EL3. The second charge generation layer CGL2 may be formed to include an N-type charge generation layer for supplying electrons to the second stack EL2 and a P-type charge generation layer for supplying holes to the third stack EL3. The N-type charge generation layer may be formed to include a metal material as a dopant.

The second charge generation layer CGL2 may also be disposed between the first sub-pixel 21 and the second sub-pixel 22, and between the second sub-pixel 22 and the third sub-pixel 23, that is to say, on the bank BK. Meanwhile, in the display device 1 according to the embodiment, since the common light-emitting layer 5 is also disposed between the sub-pixels 21, 22, and 23, a lateral leakage current may occur to adjacent sub-pixels 21, 22, and 23 through the second charge generation layer CGL2 when one of the sub-pixels emits light. However, since a bank BK having a certain height is disposed between the sub-pixels 21, 22, and 23, it is possible to prevent that a current path becomes longer and thus the lateral leakage current occurs. Furthermore, since the bank BK has an asymmetric shape, the thickness of the second charge generation layer CGL2 can be reduced at least on one side of the bank BK. As a result, the second charge generation layer CGL2 can be physically separated at least on one side of the bank BK. A detailed description of this will be provided later.

The third stack EL3 is provided on the second stack EL2 and may be formed to have a structure in which a hole transporting layer HTL, a red R emitting layer EML3, an electron transporting layer ETL, and an electron injecting layer EIL are sequentially stacked.

Referring back to FIG. 2, the second electrode 6 is formed on the common light-emitting layer 5, and the encapsulation layer 8 is formed on the second electrode 6. The color filter layer 9 is formed on the encapsulation layer 8.

Although not shown, a black matrix for preventing color mixing between the sub-pixels may be provided between the first to third color filters 91, 92, 93.

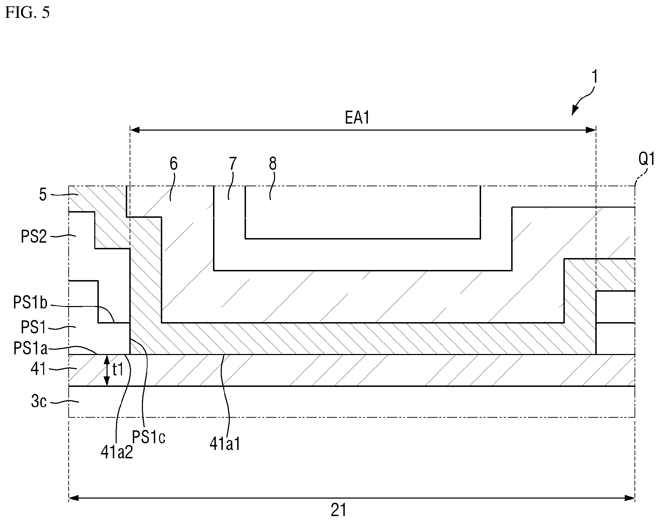

FIG. 5 is an enlarged view of a region Q1 in FIG. 2.

Referring to FIGS. 1 to 5, among top surfaces 41a1 and 41a2 of the transparent layer 41, the top surface 41a1 located in the first light-emitting area EA1 may directly contact the common light-emitting layer 5, and the top surface 41a2 located in the non-light-emitting area may directly contact the first protective layer PS1. A bottom surface PS1a of the first protective layer PS1 may directly contact the transparent layer 41 in the non-light-emitting area, and a top surface PS1b of the first protective layer PS1 may directly contact the second protective layer PS2 in the non-light-emitting area. A side surface PS1c of the first protective layer PS1 may directly contact the common light-emitting layer 5 at the boundary between the first light-emitting area EA1 and the non-light-emitting area. The second protective layer PS2 may not be disposed in the first light-emitting area EA1. The common light-emitting layer 5 may directly contact a side surface of the second protective layer PS2 and the top surface of the transparent layer 41 in the first light-emitting area EA1.

The transparent layer 41 may have a first thickness t1. The first thickness t1 may be about 5 nm or less, but is not limited thereto. For example, the first thickness t1 may be about 3 nm or less, but is not limited thereto. The transparent layer 41 has a small thickness, so that it may have a transparent property of allowing the light reflected from the reflective layer 42 to travel upward.

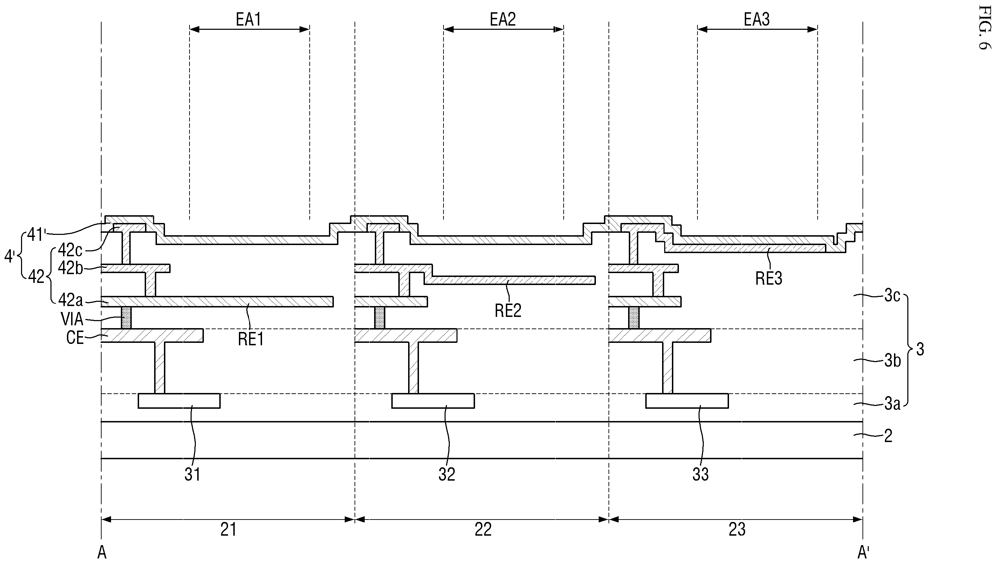

FIGS. 6 to 15 are cross-sectional views for respective process steps of a manufacturing method of the display device according to the embodiment.

Hereinafter, a manufacturing method of the display device 1 according to the embodiment will be described. In the following description of the manufacturing method of the display device 1, the repetitive descriptions of the same parts as those of the foregoing description of FIGS. 1 to 5 will be omitted.

The first insulating layer 3a, the transistors 31, 32, and 33, the second insulating layer 3b, the connection electrode CE, the third insulating layer 3c, the via VIA, and the reflective layer 42 may be formed on the substrate 2.

In some implementations, the substrate 2 may be a plastic film, a glass substrate, or a semiconductor substrate such as silicon.

The substrate 2 may be formed of or include a transparent material or an opaque material. On the substrate 2, the first sub-pixel 21, the second sub-pixel 22, and the third sub-pixel 23 are provided. The first sub-pixel 21 may be configured to emit red light R, the second sub-pixel 22 may be configured to emit blue light B, and the third sub-pixel 23 may be configured to emit green light G.

The insulating layer 3 is formed on the substrate 2. The insulating layer 3 may include the plurality of stacked insulating layers 3a, 3b, and 3c. According to the embodiment, the insulating layers 3a, 3b, and 3c may be sequentially stacked in the thickness direction and may include the same material. However, they are not limited thereto. The insulating layers 3a, 3b, and 3c may include different materials. In the insulating layer 3, circuit elements including a plurality of thin-film transistors 31, 32, and 33, various signal wirings, and capacitors are provided for each of the sub-pixels 21, 22, and 23. The signal wirings may include a gate line, a data line, a power line, and a reference line. The thin-film transistors 31, 32, and 33 may include a switching thin-film transistor, a driving thin-film transistor, and a sensing thin-film transistor. Each of the sub-pixels 21, 22, and 23 is defined by an intersecting structure of the gate lines and data lines.

The first transistor 31, the second transistor 32, and the third transistor 33 are disposed for the sub-pixels 21, 22, and 23, respectively, within the first insulating layer 3a.

The first insulating layer 3a can protect the transistors 31, 32, and 33. The first insulating layer 3a may be formed of or include an organic insulating material, but the first insulating layer 3a is not necessarily limited thereto. The first insulating layer 3a may be formed of or include an inorganic insulating material. The transistors 31, 32, and 33 may be located within the first insulating layer 3a.

The connection electrode CE may be disposed in the sub-pixels 21, 22, and 23, respectively, on the first insulating layer 3a. The second insulating layer 3b may be disposed on the first insulating layer 3a. The connection electrode CE may be disposed within the second insulating layer 3b, but the connection electrode CE is not limited thereto. The connection electrode CE is patterned for each of the first to third sub-pixels 21, 22, and 23. The connection electrode CE may be electrically connected to the transistors 31, 32, and 33. The second insulating layer 3b may be formed of or include an organic insulating material, but it is not necessarily limited thereto. The second insulating layer 3b may be formed of or include an inorganic insulating material.

The reflective layer 42 may reflect the light emitted toward the reflective layer 42 among the light emitted from the common light-emitting layer 5 of each of the sub-pixels 21, 22, and 23 to the second electrode 6 or the encapsulation layer 8. Also, the reflective layer 42 is for implementing the micro-cavity characteristics through reflection and re-reflection with the second electrode 6. To this end, the reflective layer 42 may include a reflective material for reflecting light. For example, the reflective material may be a metal, but it is not necessarily limited thereto. The reflective material may be any other materials as long as they can reflect light. For example, the reflective material may include Ti/Al, but it is not limited thereto.

The reflective layers 42 of the sub-pixels 21, 22, and 23 may be electrically connected to the transistors 31, 32, and 33 through the connection electrode CE.

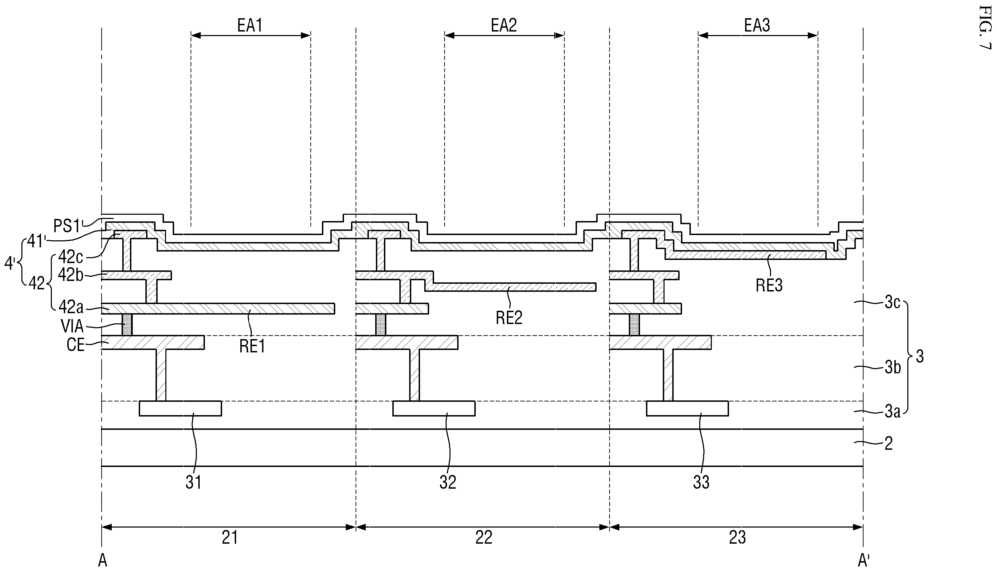

Referring to FIGS. 2 and 7, in the sub-pixels 21, 22, and 23, a transparent layer 41' is deposited (or formed) on the whole surface of the reflective layer 42. The transparent layer 41' may be formed of or include a transparent material, but is not limited thereto. The transparent layer 41' may be formed in the form of a thin film of any metal material capable of transmitting light. For example, the transparent layer 41' may include titanium nitride (TiN), but is not limited thereto. The transparent layer 41' may be formed in the form of a very thin film such that the light reflected from the reflective layer 42 can travel upward. For example, the thickness of the transparent layer 41' may be about 5 nm or less. For example, the thickness of the transparent layer 41' may be about 3 nm or less, but is not limited thereto.

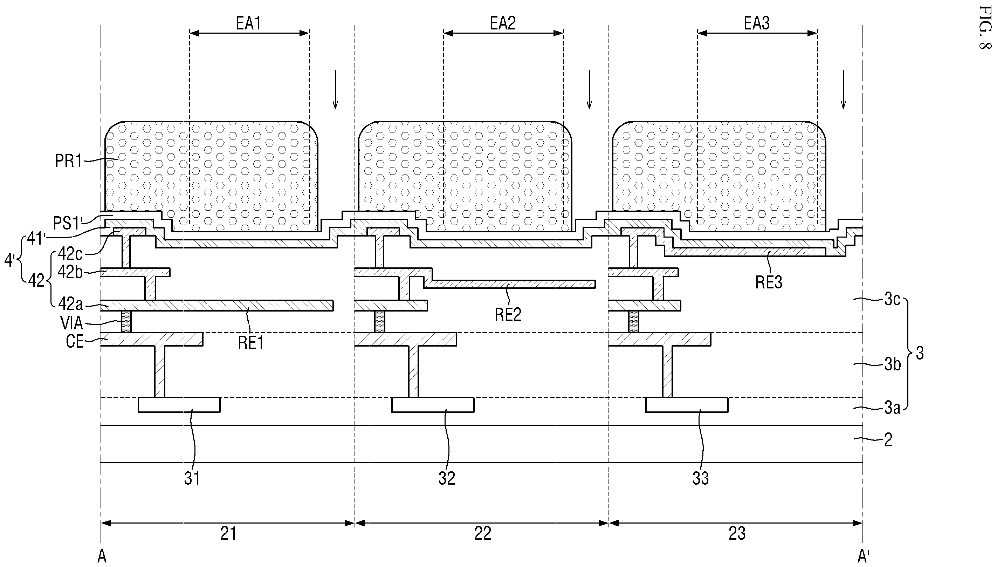

Then, referring to FIGS. 2 and 8, a first protective layer PS1' is deposited on the whole surface of the transparent layer 41'. The first protective layer PS1' may be formed of or include an inorganic material such as silicon nitride SiNx, silicon oxide SiOx, aluminum oxide Al2O3, etc. However, the embodiments of the present disclosure are not limited thereto. For example, the first protective layer PS1' may include aluminum oxide Al2O3, but is not limited thereto.

Then, referring to FIGS. 2 and 8, a first photoresist PR1 is formed on the first protective layer PS1'. The first photoresist PR1 may function as a mask in the first etching process to be described later. The first etching process may be a process of physically separating the transparent layer (see reference numeral 41 in FIG. 2) located in the sub-pixels 21, 22, and 23 respectively from the transparent layer (see reference numeral 41 in FIG. 2) located in adjacent sub-pixels 21, 22, and 23. Therefore, the first photoresist PR1 is formed in the area where the transparent layer 41 is disposed in the sub-pixels 21, 22, and 23 respectively in FIG. 2. The first photoresist PR1 is not disposed in the area where the transparent layer 41 is not disposed and may expose the first protective layer PS1' in the area.

As shown in FIG. 8, the first protective layer PS1' and the transparent layer 41' are first etched by using the first photoresist PR1 as a mask. The first etching may be a dry etching. Etching gas used in the first etching may have a good etching selection ratio for the first protective layer PS1' and the transparent layer 41', respectively. For example, a difference in etching selection ratio of the first protective layer PS1' and the transparent layer 41' to the etching gas used in the first etching may be about 10 % or less, but the embodiments of the present disclosure are not limited thereto.

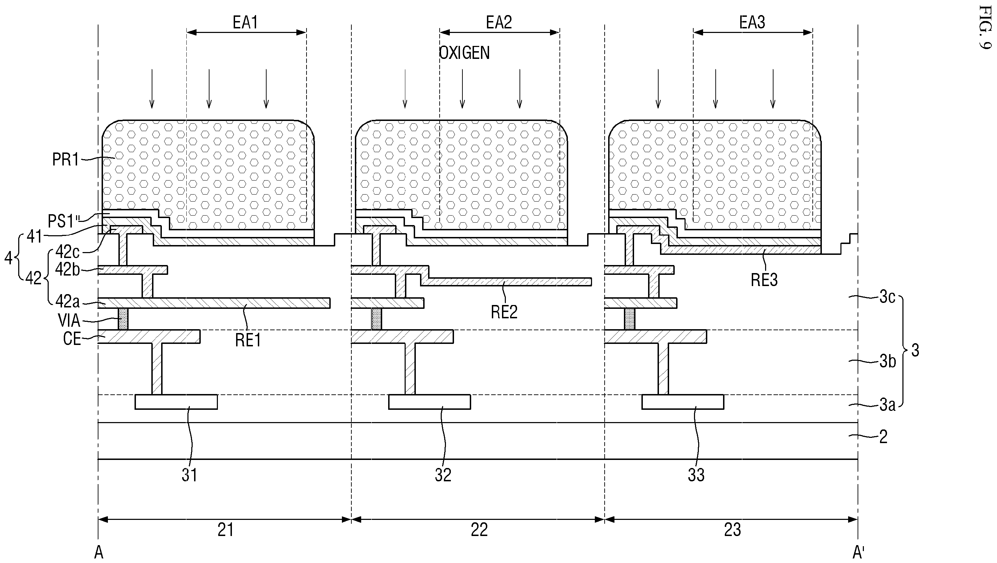

Then, as shown in FIGS. 2 and 9, after the first etching of the transparent layer 41' and the first protective layer PS1' in FIG. 8, the transparent layer 41 and a first protective layer PS1" are formed. After the first etching, the first photoresist PR1 is removed. The removal of the first photoresist PR1 may be performed using an ashing process. The ashing process may include an oxygen plasma process. In other words, when the first photoresist PR1 is exposed to oxygen OXYGEN in plasma form, the first photoresist PR1 can be removed. As mentioned above, the transparent layer 41 is manufactured to have a very small thickness in order to increase light transmittance. If the thin transparent layer 41 is exposed to oxygen plasma, it may be oxidized. If the transparent layer 41 is oxidized, the thickness of the transparent layer 41 can vary in different parts (area within the light-emitting areas EA1, EA2, and EA3), and thus, the display quality may be degraded. However, in the case of the display device according to the embodiments, during the process of removing the first photoresist PR1, since the first protective layer PS1" is disposed on the transparent layer 41, the oxidation of the transparent layer 41 can be prevented in advance.

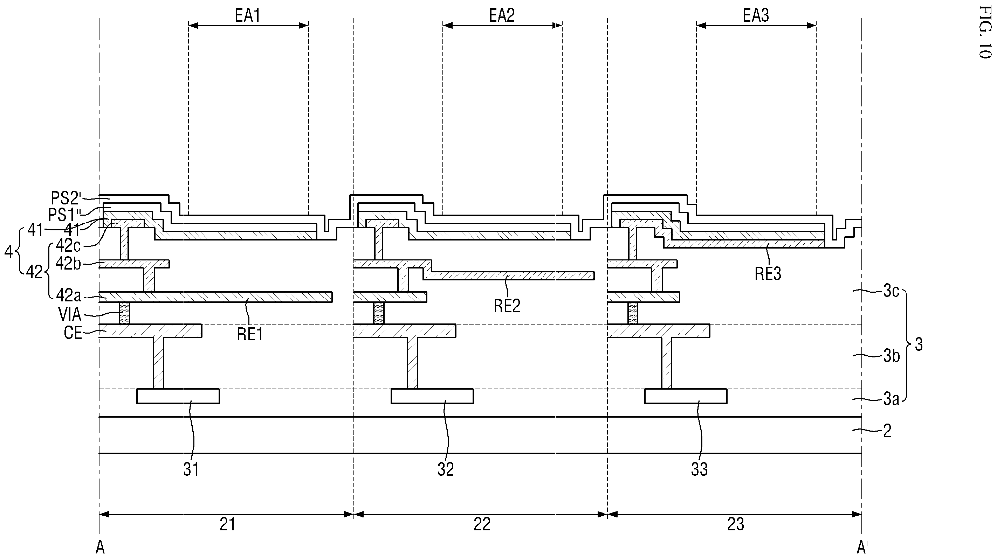

As shown in FIGS. 2 and 10, a second protective layer PS2' is deposited on the whole surfaces of the first etched transparent layer 41 and the first protective layer PS1". The second protective layer PS2' may be formed of or include an inorganic material such as silicon nitride SiNx, silicon oxide SiOx, aluminum oxide Al2O3, etc. However, the embodiments of the present disclosure are not limited thereto. For example, the second protective layer PS2' may include silicon nitride SiNx or silicon oxide SiOx, but is not limited thereto. In the area where the transparent layer 41 is not disposed, the second protective layer PS2' may directly contact the insulating layer 3 (e.g., the third insulating layer 3c).

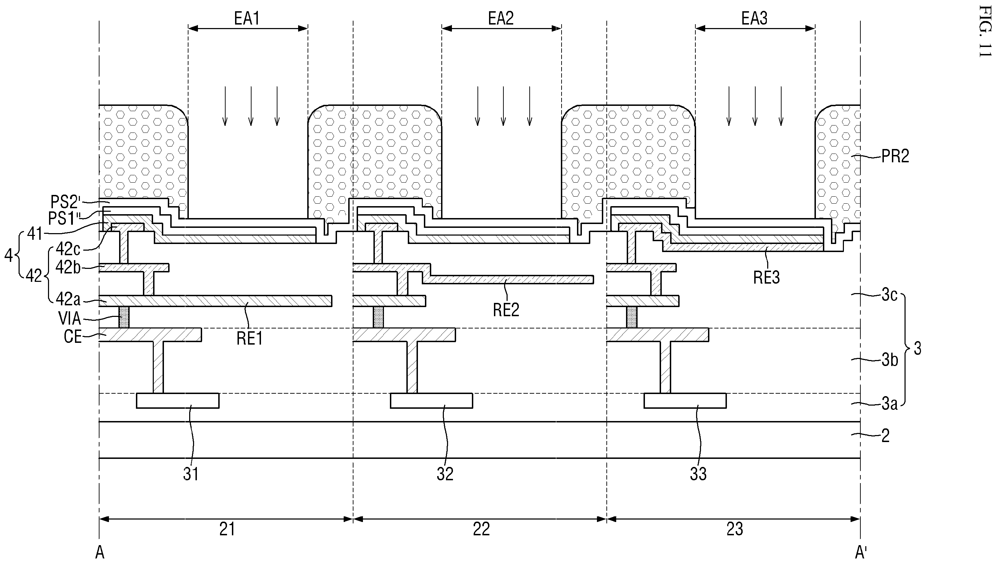

Then, as shown in FIGS. 2 and 11, a second photoresist PR2 is formed on the second protective layer PS2'. The second photoresist PR2 may be formed in the non-light-emitting area of each of the sub-pixels 21, 22, and 23, and may not be formed in the light-emitting areas EA1, EA2, and EA3. The second photoresist PR2 may function as a mask in a second etching process. The second etching may be a process of removing the second protective layer PS2' located in each of the light-emitting areas EA1, EA2, and EA3 and of exposing the top surface of the first protective layer PS1" on the light-emitting areas EA1, EA2, and EA3.

As shown in FIG. 11, the second protective layer PS2' is second etched using the second photoresist PR2 as a mask. The second etching may be a dry etching. Etching gas used in the second etching may have a good etching selection ratio for the second protective layer PS2'. In the second etching, the second protective layer PS2' may be etched, but the first protective layer PS1" and the transparent layer 41 may not be etched. For example, the etching selection ratio of the second protective layer PS2' to the etching gas may be three times or more than the etching selection ratio of the first protective layer PS1" to the etching gas and the etching selection ratio of the transparent layer 41 to the etching gas, respectively. For example, the etching selection ratio of the second protective layer PS2' to the etching gas may be about seven times or more than the etching selection ratio of the first protective layer PS1" to the etching gas, and the etching selection ratio of the second protective layer PS2' to the etching gas may be about four times or more than the etching selection ratio of the transparent layer 41 to the etching gas. For example, the etching selection ratio of the second protective layer PS2' to the etching gas: the etching selection ratio of the first protective layer PS1" to the etching gas: the etching selection ratio of the transparent layer 41 to the etching gas may be 28 : 4 : 7. However, the embodiments of the present disclosure are not limited to this.

In the second etching process, even though the etching selection ratio of the second protective layer PS2' to the etching gas may be about four times or more than the etching selection ratio of the transparent layer 41 to the etching gas, the transparent layer 41 may be partially etched by the etching gas when over-etching occurs. However, according to the manufacturing method of the display device 1 according to the embodiment, in the second etching process, since the first protective layer PS1" is disposed on the transparent layer 41 and protects the transparent layer 41, the etching of the transparent layer 41 may not occur.

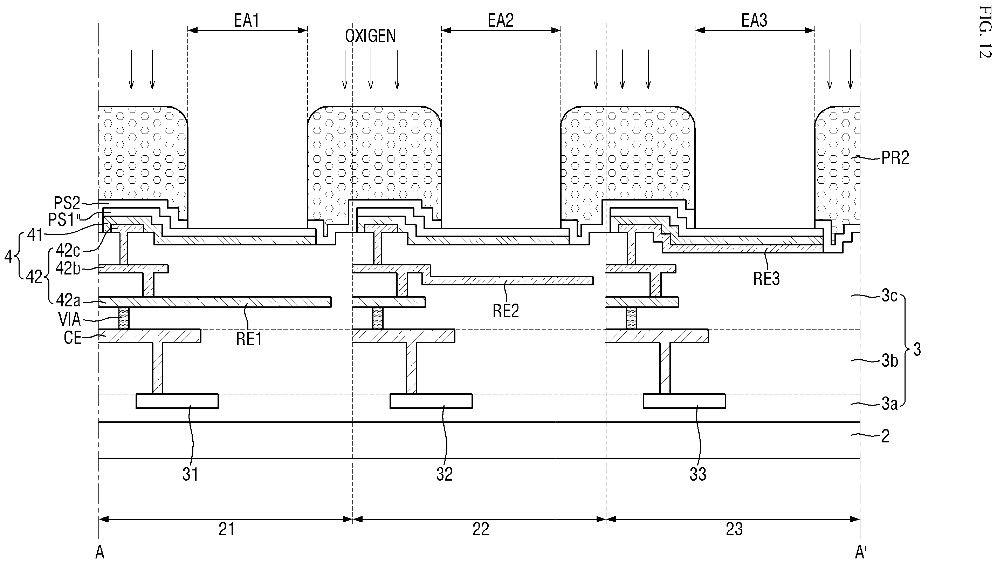

Then, as shown in FIGS. 2 and 12, after the second etching of the second protective layer PS2' in FIG. 11, the second protective layer PS2 is formed. The second protective layer PS2 may not be disposed in the light-emitting areas EA1, EA2, and EA3 of the sub-pixels 21, 22, and 23. After the second etching, the second photoresist PR2 is removed. The removal of the second photoresist PR2 may be performed using an ashing process. The ashing process may include an oxygen plasma process. In other words, when the second photoresist PR2 is exposed to oxygen OXYGEN in plasma form, the second photoresist PR2 can be removed. As mentioned above, the transparent layer 41 is manufactured to have a very small thickness in order to increase light transmittance. If the thin transparent layer 41 is exposed to oxygen plasma, it may be oxidized. If the transparent layer 41 is oxidized, the thickness of the transparent layer 41 can vary in different parts (area within the light-emitting areas EA1, EA2, and EA3), and thus, the display quality may be degraded. However, in the case of the display device according to the embodiments, during the process of removing the second photoresist PR2, since the first protective layer PS1" is disposed on the transparent layer 41, the oxidation of the transparent layer 41 can be prevented in advance.

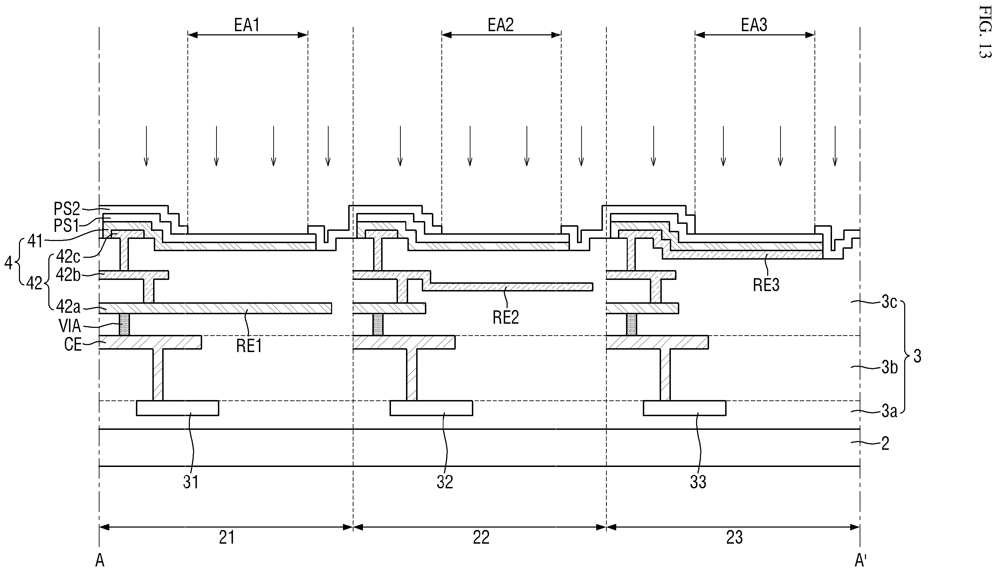

Then, as shown in FIGS. 2 and 13, a third etching is performed. The third etching may be a wet etching. An etchant used in the third etching may have a good etching selection ratio for the first protective layer PS1". In the third etching, the first protective layer PS1" may be etched, but the second protective layer PS2 and the transparent layer 41 may not be etched. For example, the etching selection ratio of the first protective layer PS1" to the etchant may be five times or more than the etching selection ratio of the second protective layer PS2 to the etching gas and the etching selection ratio of the transparent layer 41 to the etchant, respectively. For example, the etching selection ratio of the first protective layer PS1" to the etchant may be about 100 times or more than the etching selection ratio of the second protective layer PS2 to the etchant, and the etching selection ratio of the first protective layer PS1" to the etchant may be about eight times or more than the etching selection ratio of the transparent layer 41 to the etchant. For example, the etching selection ratio of the first protective layer PS1" to the etchant: the etching selection ratio of the second protective layer PS2 to the etchant: the etching selection ratio of the transparent layer 41 to the etchant may be 0 : 10 : 1. However, the embodiments of the present disclosure are not limited to this.

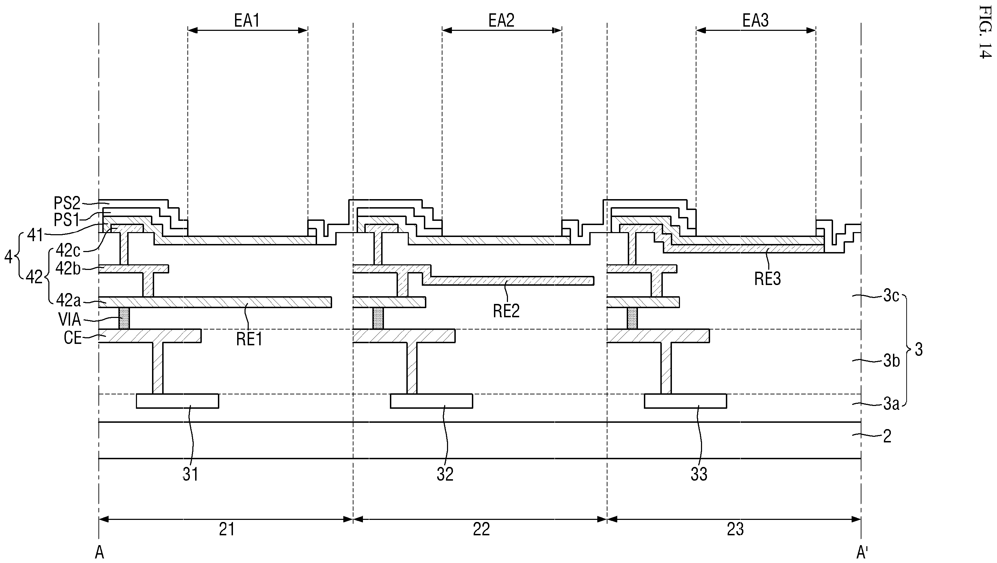

After the third etching process in FIG. 13, as shown in FIG. 14, the first protective layer PS1 is formed. The first protective layer PS1 may expose the top surface of the transparent layer 41, in the light-emitting areas EA1, EA2, and EA3.

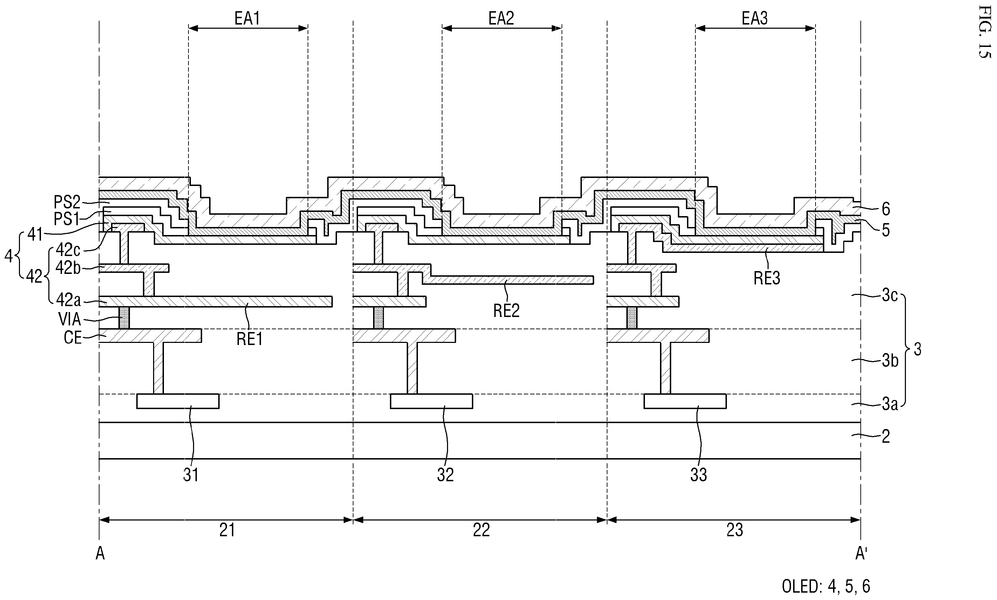

Then, as shown in FIGS. 2 and 15, the common emitting layer 5 and the second electrode 6 are sequentially stacked on the protective layers PS1 and PS2 and the transparent layer 41.

The common light-emitting layer 5 may be configured to emit white light. For example, the common light-emitting layer 5 may be provided with a two-stack structure including a blue light-emitting layer, a yellow-green light-emitting layer, and a charge generation layer, or a three-stack structure including the blue light-emitting layer, a green light-emitting layer, a red light-emitting layer, and the charge generation layer, thereby emitting white light. However, the common light-emitting layer 5 is not necessarily limited thereto. The common light-emitting layer 5 may be provided as multiple layers including more than three stacks as long as the common light-emitting layer 5 can emit white light.

The common light-emitting layer 5 may be formed as a common layer across the entire first to third sub-pixels 21, 22, and 23. Therefore, the common light-emitting layer 5 may cover the first electrode 4 disposed in each sub-pixel and the first and second protective layers PS1 and PS2 disposed between the sub-pixels respectively.

The second electrode 6 is provided to form an electric field together with the first electrode 4 and may function as a cathode. The second electrode 6 is disposed on the top surface of the common light-emitting layer 5 opposite to the bottom surface of the common light-emitting layer 5 where the first electrode 4 is in contact, and may be provided as a common layer across the entire first to third sub-pixels 21, 22, and 23.

In the case of a top emission type, the second electrode 6 may be provided as a transparent electrode. In the case of a bottom emission type, the second electrode 6 may be provided as an opaque electrode including a reflective material. In the case of the top emission type, the second electrode 6 may be formed as a translucent electrode in order to improve light extraction efficiency by using micro-cavity characteristics. Since the display device improves the light extraction efficiency by using the micro-cavity characteristics in the top emission type, the second electrode formed as a translucent electrode will be described as an example.

Hereinafter, display devices according to other embodiments will be described. In the description of the following embodiments, detailed descriptions or redundant descriptions of the components that are the same as or similar to those described in FIGS. 1 to 15 will be omitted.

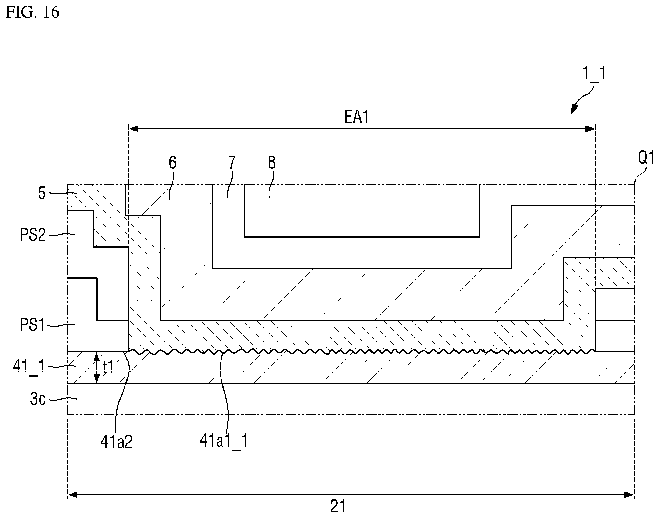

Figure 16 is a cross-sectional view of a display device according to another embodiment.

Referring to FIG. 16, a display device 1_1 according to the embodiment differs from the display device 1 according to FIGS. 2 and 5 in that it includes a transparent layer 41_1.

A top surface 41a1_1 in the first light-emitting area EA1 of the transparent layer 41_1 may include surface irregularities. For example, the surface 41a1_1 in the first light-emitting area EA1 of the transparent layer 41_1 may have a larger surface roughness than that of a top surface 41a2 in the non-light-emitting area. The reason why the top surface 41a1_1 in the first light-emitting area EA1 of the transparent layer 41_1 has a larger surface roughness than that of the top surface 41a2 in the non-light-emitting area may be caused by the over-etching that occurs in the third etching process described in FIG. 13. As described in FIG. 13, the etchant used in the third etching has a good etching selection ratio for the first protective layer PS1". In the third etching, the first protective layer PS1" is etched, but it is preferable that the second protective layer PS2 and the transparent layer 41_1 are not etched. However, the etching selection ratio of the first protective layer PS1" to the etchant is about 100 times or more than the etching selection ratio of the second protective layer PS2 to the etchant, and the second protective layer PS2 is hardly etched even if over-etching occurs. However, since the etching selection ratio of the first protective layer PS1" to the etchant is about eight times or more than the etching selection ratio of the transparent layer 41_1 to the etchant, when the over-etching occurs in the third etching, a portion of the top surface of the transparent layer 41_1 may be etched. Since the transparent layer 41_1 is covered by the second protective layer PS2 in the non-light-emitting area, the top surface 41a2 of the transparent layer 41_1 in the non-light-emitting area may not be etched even if the over-etching occurs in the third etching.

Since other descriptions have been made above in FIGS. 1 to 15, detailed descriptions thereof will be omitted below.

FIG. 17 is a cross-sectional view of a display device according to further another embodiment.

Referring to FIG. 17, a display device 1_2 according to the embodiment differs from the display device 1 according to FIGS. 2 and 5 in that it includes a transparent layer 41_2.

The transparent layer 41_2 may include a first portion 41P1 disposed in the first light-emitting area EA1 and a second portion 41P2 disposed in the non-light-emitting area. A thickness t2 of the first portion 41P1 may be less than a thickness t1 of the second portion 41P2.

The reason why the thickness t2 of the first portion 41P1 is less than the thickness t1 of the second portion 41P2 may be caused by the over-etching that occurs in the third etching process described in FIG. 13. As described in FIG. 13, the etchant used in the third etching has a good etching selection ratio for the first protective layer PS1". In the third etching, the first protective layer PS1" is etched, but it is preferable that the second protective layer PS2 and the transparent layer 41 are not etched. However, the etching selection ratio of the first protective layer PS1" to the etchant is about 100 times or more than the etching selection ratio of the second protective layer PS2 to the etchant, and the second protective layer PS2 is hardly etched even if over-etching occurs. However, since the etching selection ratio of the first protective layer PS1" to the etchant is about eight times or more than the etching selection ratio of the transparent layer 41 to the etchant, when the over-etching occurs in the third etching, a portion of the top surface of the transparent layer 41 may be etched. Therefore, since the second portion 41P2 in the non-light-emitting area is covered by the second protective layer PS2, the first thickness t1 is maintained even if the over-etching occurs in the third etching. However, if the first portion 41P1 in the first light-emitting area EA1 is over-etched, a portion of the first portion 41P1 is etched, and the first portion 41P1 may have the second thickness t2 smaller than the first thickness t1.

Since other descriptions have been made above in FIGS. 1 to 15, detailed descriptions thereof will be omitted below.

FIG. 18 is a cross-sectional view of a display device according to yet another embodiment.

Referring to FIG. 18, a display device 1_3 according to the embodiment differs from the display device 1_2 according to FIG. 17 in that the top surface 41a1_1 of the first portion 41P1 (see FIG. 17) includes surface irregularities (see FIG. 16).

In more detail, a transparent layer 41_3 may include the first portion 41P1 disposed in the first light-emitting area EA1 and the second portion 41P2 disposed in the non-light-emitting area. The thickness t2 of the first portion 41P1 may be less than the thickness t1 of the second portion 41P2.

Also, as in FIG. 16, the top surface 41a1_1 of the first portion 41P1 may include surface irregularities. For example, the top surface 41a1_1 of the first portion 41P1 may have a larger surface roughness than that of the top surface 41a2 of the second portion 41P2 disposed in the non-light-emitting area.

Since other descriptions have been made above in FIGS. 16 and 17, detailed descriptions thereof will be omitted below.

FIG. 19 is a cross-sectional view of a display device according to still another embodiment.

Referring to FIG. 19, a display device 1_4 according to the embodiment differs from the display device 1 according to FIGS. 2 and 5 in that it may include a first protective layer PS1_1.

In more detail, the first protective layer PS1_1 may include a recessed portion IDP that is recessed from the first light-emitting area EA1 toward the non-light-emitting area. A side surface PS1c of the first protective layer PS1_1 may have a curved shape. Due to the recessed portion IDP, compared to a top surface PS1b of the first protective layer PS1_1, a bottom surface PS1a of the first protective layer PS1_1 may be positioned by being recessed from the first light-emitting area EA1 toward the non-light-emitting area. In other words, the end of the bottom surface PS1a may be located farther away from the first light-emitting area EA1 compared to the end of the top surface PS1b.

The recessed portion IDP may be formed by the over-etching that occurs in the third etching process described in FIG. 13. In the third etching process, the first protective layer PS1_1 may be over-etched by the etchant, forming the recessed portion IDP.

While FIG. 19 shows that the end of the bottom surface PS1a is located farther away from the first light-emitting area EA1 compared to the end of the top surface PS1b.However, the end of the bottom surface PS1a is not limited thereto, and conversely, the end of the bottom surface PS1a may be located closer to the first light-emitting area EA1 compared to the end of the top surface PS1b, or the end of the bottom surface PS1a and the end of the top surface PS1b may be positioned on the same line.

Since other descriptions have been made above in FIGS. 1 to 15, detailed descriptions thereof will be omitted below.

FIG. 20 is a cross-sectional view of a display device according to still another embodiment.

Referring to FIG. 20, a display device 1_5 according to the embodiment differs from the display device 1_4 according to FIG. 19 in that it includes the transparent layer 41_1 described in FIG. 16.

In more detail, the top surface 41a1_1 in the first light-emitting area EA1 of the transparent layer 41_1 may include surface irregularities. For example, the surface 41a1_1 in the first light-emitting area EA1 of the transparent layer 41_1 may have a larger surface roughness than that of the top surface 41a2 in the non-light-emitting area.

The first protective layer PS1_1 may include the recessed portion IDP that is recessed from the first light-emitting area EA1 toward the non-light-emitting area.

Since other descriptions have been made above in FIGS. 16 and 19, detailed descriptions thereof will be omitted below.

FIG. 21 is a cross-sectional view of a display device according to still another embodiment.

Referring to FIG. 21, a display device 1_6 according to the embodiment differs from the display device 1_4 according to FIG. 19 in that it includes the transparent layer 41_2 described in FIG. 17.

In more detail, the transparent layer 41_2 may include the first portion 41P1 disposed in the first light-emitting area EA1 and the second portion 41P2 disposed in the non-light-emitting area. The thickness t2 of the first portion 41P1 may be less than the thickness t1 of the second portion 41P2.

The first protective layer PS1_1 may include the recessed portion IDP that is recessed from the first light-emitting area EA1 toward the non-light-emitting area.

Since other descriptions have been made above in FIGS. 17 and 19, detailed descriptions thereof will be omitted below.

FIG. 22 is a cross-sectional view of a display device according to still another embodiment.

Referring to FIG. 22, a display device 1_7 according to the embodiment differs from the display device 1_4 according to FIG. 19 in that it includes the transparent layer 41_3 described in FIG. 18.

In more detail, the transparent layer 41_3 may include the first portion 41P1 disposed in the first light-emitting area EA1 and the second portion 41P2 disposed in the non-light-emitting area. The thickness t2 of the first portion 41P1 may be less than the thickness t1 of the second portion 41P2.

Also, as in FIG. 16, the top surface 41a1_1 of the first portion 41P1 may include surface irregularities. For example, the top surface 41a1_1 of the first portion 41P1 may have a larger surface roughness than that of the top surface 41a2 of the second portion 41P2 disposed in the non-light-emitting area.

The first protective layer PS1_1 may include the recessed portion IDP that is recessed from the first light-emitting area EA1 toward the non-light-emitting area.

Since other descriptions have been made above in FIGS. 18 and 19, detailed descriptions thereof will be omitted below.

The display device according to various embodiments of the present disclosure may be described as follows.

The display device according to various embodiments of the present disclosure includes: a substrate which includes a plurality of sub-pixels; a transparent layer which is disposed in the plurality of sub-pixels, respectively; a first protective layer which is disposed on the transparent layer; and a second protective layer which is disposed on the first protective layer. The sub-pixel includes a light-emitting area where the transparent layer is exposed by the first protective layer and the second protective layer, and a non-light-emitting area around the light-emitting area.

In the display device according to various embodiments of the present disclosure, the first protective layer and the second protective layer may be arranged at a boundary between the light-emitting area and the non-light-emitting area.

The display device according to various embodiments of the present disclosure may further include an insulating layer disposed between the substrate and the transparent layer. In the non-light-emitting area, the second protective layer may contact directly a top surface of the insulating layer and a side surface of the transparent layer.

The display device according to various embodiments of the present disclosure may further include a common light-emitting layer disposed on the second protective layer, and a second electrode disposed on the common light-emitting layer.

The display device according to various embodiments of the present disclosure may further include a reflective electrode disposed between the substrate and the transparent layer.

In the display device according to various embodiments of the present disclosure, the reflective electrode may be electrically connected to the transparent layer. The display device may further include a transistor disposed between the substrate and the transparent layer. The transistor may be electrically connected to the reflective electrode.

In the display device according to various embodiments of the present disclosure, the sub-pixel may include a first sub-pixel, a second sub-pixel, and a third sub-pixel. A distance between the reflective electrode and the transparent layer in the first sub-pixel may be greater than a distance between the reflective electrode and the transparent layer in the second sub-pixel and a distance between the reflective electrode and the transparent layer in the third sub-pixel, respectively. A distance between the reflective electrode and the transparent layer in the second sub-pixel may be greater than the distance between the reflective electrode and the transparent layer in the third sub-pixel.

In the display device according to various embodiments of the present disclosure, a thickness of the transparent layer may be 5 nm or less.

In the display device according to various embodiments of the present disclosure, an etching selection ratio of the second protective layer may be three times or more than an etching selection ratio of the first protective layer and an etching selection ratio of the transparent layer, respectively.

In the display device according to various embodiments of the present disclosure, an etching selection ratio of the first protective layer may be five times or more than an etching selection ratio of the second protective layer and an etching selection ratio of the transparent layer, respectively.

In the display device according to various embodiments of the present disclosure, a surface roughness of the transparent layer in the light-emitting area may be larger than a surface roughness of the transparent layer in the non-light-emitting area.

In the display device according to various embodiments of the present disclosure, a thickness of the transparent layer in the light-emitting area may be less than a thickness of the transparent layer in the non-light-emitting area.

In the display device according to various embodiments of the present disclosure, a thickness of the transparent layer in the light-emitting area may be less than a thickness of the transparent layer in the non-light-emitting area.

In the display device according to various embodiments of the present disclosure, the first protective layer may include a bottom surface contacting the transparent layer, and a top surface contacting the second protective layer. Compared to the top surface, the bottom surface of the first protective layer may be recessed toward the non-light-emitting area.

A manufacturing method of the display device according to various embodiments of the present disclosure may include: forming a transparent layer on a substrate including a sub-pixel having a light-emitting area and a non-light-emitting area around the light-emitting area; forming a first protective layer on the transparent layer; performing a first etching on the transparent layer and the first protective layer; forming a second protective layer on the first etched first protective layer; performing a second etching on the second protective layer on the light-emitting area; and performing a third etching on the first protective layer on the light-emitting area.

In the manufacturing method of the display device according to various embodiments of the present disclosure, in performing the first etching, the transparent layer and the first protective layer may be etched using a first photoresist on the first protective layer.

The manufacturing method of the display device according to various embodiments of the present disclosure may further include removing the first photoresist between the performing the first etching and the forming the second protective layer. The removal of the first photoresist may be performed by oxygen plasma.

In the manufacturing method of the display device according to various embodiments of the present disclosure, in performing the second etching, the second protective layer may be etched by using the first photoresist on the second protective layer.

The manufacturing method of the display device according to various embodiments of the present disclosure may further include removing the first photoresist between the performing the second etching and the performing the third etching. The removal of the first photoresist may be performed by oxygen plasma.

In the manufacturing method of the display device according to various embodiments of the present disclosure, an etching selection ratio of the second protective layer to etching gas of the second etching may be three times or more than an etching selection ratio of the first protective layer to the etching gas and an etching selection ratio of the transparent layer to the etching gas, respectively. An etching selection ratio of the first protective layer to etching gas of the third etching may be five times or more than an etching selection ratio of the second protective layer to the etching gas and an etching selection ratio of the transparent layer to the etching gas, respectively.

The embodiments and implementations disclosed above are examples of the disclosed technology, and thus various enhancements and variations to the disclosed embodiments and implementations and other embodiments and implementations can be made for implementing the disclosed technology based on what is described and illustrated in this patent document.

## Claims

1. A display device comprising:
a substrate;
a plurality of sub-pixels supported by the substrate and configured to emit light of different colors;
a transparent layer disposed in the plurality of sub-pixels;
a first protective layer disposed on the transparent layer; and
a second protective layer disposed on the first protective layer,
wherein a sub-pixel of the plurality of sub-pixel includes a light-emitting area which emits light, and a non-light-emitting area around the light-emitting area, and the first protective layer and the second protective layer are structured to expose the transparent layer.

2. The display device according to claim 1, wherein the first protective layer and the second protective layer are arranged to define a boundary between the light-emitting area and the non-light-emitting area.

3. The display device according to claim 2, further comprising an insulating layer disposed between the substrate and the transparent layer, wherein, in the non-light-emitting area, the second protective layer directly contacts a top surface of the insulating layer and a side surface of the transparent layer.

4. The display device according to claim 1, further comprising a common light-emitting layer disposed on the second protective layer, and a second electrode disposed on the common light-emitting layer.

5. The display device according to claim 1, further comprising a reflective electrode disposed between the substrate and the transparent layer.

6. The display device according to claim 5, wherein the reflective electrode is electrically connected to the transparent layer, wherein the display device further comprises a transistor disposed between the substrate and the transparent layer, and wherein the transistor is electrically connected to the reflective electrode.

7. The display device according to claim 5,
wherein the plurality of sub-pixels includes a first sub-pixel, a second sub-pixel, and a third sub-pixel,
wherein a distance between the reflective electrode and the transparent layer in the first sub-pixel is greater than a distance between the reflective electrode and the transparent layer in the second sub-pixel and a distance between the reflective electrode and the transparent layer in the third sub-pixel, and
wherein the distance between the reflective electrode and the transparent layer in the second sub-pixel is greater than the distance between the reflective electrode and the transparent layer in the third sub-pixel.

8. The display device according to claim 1, wherein a thickness of the transparent layer is 5 nm or less.

9. The display device according to claim 1, wherein an etching selection ratio of the second protective layer is three times or more than an etching selection ratio of the first protective layer and an etching selection ratio of the transparent layer.

10. The display device according to claim 1, wherein an etching selection ratio of the first protective layer is five times or more than an etching selection ratio of the second protective layer and an etching selection ratio of the transparent layer.

11. The display device according to claim 1, wherein a surface roughness of the transparent layer in the light-emitting area is larger than a surface roughness of the transparent layer in the non-light-emitting area.

12. The display device according to claim 1, wherein a thickness of the transparent layer in the light-emitting area is less than a thickness of the transparent layer in the non-light-emitting area.

13. The display device according to claim 1, wherein the first protective layer comprises a recessed portion toward the non-light-emitting area.

14. The display device according to claim 13, wherein the first protective layer comprises a bottom surface contacting the transparent layer, and a top surface contacting the second protective layer, and wherein, compared to the top surface, the bottom surface of the first protective layer is recessed toward the non-light-emitting area.

15. A manufacturing method of manufacturing a display device, comprising:
forming a transparent layer on a sub-pixel having a light-emitting area and a non-light-emitting area around the light-emitting area;
forming a first protective layer on the transparent layer;
performing a first etching on the transparent layer and the first protective layer;
forming a second protective layer on the first etched first protective layer;
performing a second etching on the second protective layer in the light-emitting area; and
performing a third etching on the first protective layer in the light-emitting area.

16. The manufacturing method of claim 15, wherein the performing of the first etching includes etching the transparent layer and the first protective layer using a first photoresist on the first protective layer.

17. The manufacturing method of claim 16, further comprising, after the performing of the first etching and before the disposing of the second protective layer, removing the first photoresist using oxygen plasma.

18. The manufacturing method of claim 15, wherein the performing of the second etching includes etching the second protective layer using the first photoresist on the second protective layer.

19. The manufacturing method of claim 18, further comprising, , after the performing of the second etching and before the performing of the third etching, removing the first photoresist using oxygen plasma.

20. The manufacturing method of claim 15, wherein an etching selection ratio of the second protective layer to etching gas of the second etching is three times or more than an etching selection ratio of the first protective layer to the etching gas and an etching selection ratio of the transparent layer to the etching gas, and wherein an etching selection ratio of the first protective layer to etching gas of the third etching is five times or more than an etching selection ratio of the second protective layer to the etching gas and an etching selection ratio of the transparent layer to the etching gas.
